# EUROPEAN PATENT SPECIFICATION

(11) **EP 2 762 326 B1**
(45) Date of publication and mention of the grant of the patent: **23.08.2017**
(21) Application number: 12835891.8
(22) Date of filing: 19.07.2012
(51) Int. Cl.: B41N 3/08, B41M 1/06, B41C 1/10, G03F 7/30

(54) **PRINTING METHOD USING ON PRESS DEVELOPMENT LITHOGRAPHIC PRINTING PLATE PRECURSOR**
DRUCKVERFAHREN MIT EINEM LITHOGRAPHISCHEN DRUCKPLATTENVORLÄUFER MIT ENTWICKLUNG AUF DER DRUCKPRESSE
PROCÉDÉ D'IMPRESSION UTILISANT UN PRÉCURSEUR DE PLAQUE D'IMPRESSION LITHOGRAPHIQUE À DÉVELOPPEMENT SUR PRESSE

(30) Priority: 30.09.2011 JP 2011218545
(43) Date of publication of application: 06.08.2014
(73) Proprietor: FUJIFILM Corporation, Tokyo 106-0031 (JP)
(72) Inventor: FUJIKI Yuzo, Haibara-gun Shizuoka (JP); AOSHIMA Koji, Haibara-gun Shizuoka (JP); YAGI Yoshihiro, Haibara-gun (JP)
(74) Representative: Hoffmann Eitle
(86) International application number: PCT/JP2012/068341
(87) International publication number: WO 2013/046877

(56) References cited:
- JP-A- 2004 314 530
- JP-A- 2005 088 454
- JP-A- 2005 262 636

## Description

### TECHNICAL FIELD

The present invention relates to a printing method using a lithographic printing plate precursor of on-press development type. In particular, it relates to a printing method in which a number of waste sheets at the start of printing accompanied with on-press development is small and which avoids the occurrence of unevenness in printed materials.

### BACKGROUND ART

Heretofore, a so-called lithographic printing plate precursor of on-press development type capable of being developed with at least one of dampening water and ink on a printing machine has been known as a means to improve productivity of lithographic printing because a developing step using a developer can be omitted so that a plate making time is reduced and also there is an advantage of cost reduction or the like due to that a development processing apparatus and a developer are not necessary.

Development mechanism for a lithographic printing plate precursor of on-press development type relating to the invention is considered as follows: (1) Dampening step: Dampening water supplied from a dampening roller to a surface of the lithographic printing plate precursor penetrates into an image-recording layer. As the penetration proceeds, a layer of the dampening water is generated at the interface between an image-recording layer and a support to reduce adhesion between the image-recording layer and the support. (2) Inking step: An inking roller is brought into contact with the surface of the lithographic printing plate precursor and due to viscosity of the ink the image-recording layer reduced the adhesion with the support is peeled off to be removed, whereby the development is completed. After the development, printed materials are obtained in a subsequent usual printing step.

As a specific example of such on-press development, there is disclosed a method wherein an image-drawn lithographic printing plate precursor capable of undergoing on-press development is mounted on a printing machine cylinder, a dampening water roller of printing machine is brought into contact with a surface of the lithographic printing plate precursor to supply dampening water to the lithographic printing plate precursor, after 10 rotations of the printing cylinder an ink roller is brought into contact with the surface of the lithographic printing plate precursor to supply ink, and after further 10 rotations of the printing cylinder printed materials without stain in the non-image area are obtained (see Patent Documents 1 and 2).

However, a number of printing papers required for obtaining printed materials without stain in the on-press development as described above increases several times in comparison with a lithographic printing plate obtained by plate making according to the common wet development. This means increase in the number of waste sheets to make a weak point in the lithographic printing plate precursor of on-press development type.

As a method for accelerating the on-press development to decrease the number of waste sheets, a method wherein a supply amount of dampening water in the dampening step increases to a large extent at the start of on-press development in comparison with at the end of on-press development, a method wherein a peripheral velocity of printing cylinder (plate cylinder) at the on-press development is changed, and the like are known (see, for example, Patent Document 3).

However, according to a method using a conventional printing sequence as the methods described above, when a local abrasion or deformation is present on the dampening water roller, a local unevenness occurs in a damping feed to cause unevenness in printed materials from the lithographic printing plate obtained.
Patent Document 4 describes a lithographic printing method that aims at eliminating a contamination of damping water with a removed component from a development process. The lithographic printing plate with an image recording layer which can be removed by water or an aqueous component, is exposed to light in an image fashion and fitted to a plate cylinder of the printer, or the original lithographic printing plate is fitted to the plate cylinder of the printer, then is exposed to light in an image fashion and water or an aqueous component is supplied to the surface of the original plate after the exposure using a non-contact supply process. Following these procedures, the unexposed part of the image recording layer is transferred to the surface of an ink roller and/or a blanket, then is developed and the printing plate thus prepared is used for printing. For the method for supplying the aqueous component or the like in a non-contact manner, a direct spray method to the surface of the original lithographic printing plate, a brush water supply device, a Smith spray water supply device or a mist spraying water supply device, is preferably adopted.
Patent Document 5 wishes to solve the problems that in a lithographic printing plate to be developed with dampening water on a printing machine, scumming occurs due to insufficiency in an amount of dampening water in restart of printing. The document proposes a method for printing with a lithographic printing plate to be developed with dampening water on the printing machine, when printing is resumed after once stopping the printing, ([alpha]) a process for feeding dampening water by making a dampening roller contact to the lithographic printing plate rotating the plate cylinder and ([beta]) a process for feeding ink by making an ink roller contact the ink are provided as a print resuming preparation process. The dampening roller in the ([alpha]) process is rotated three or more times in a state of contacting the plate and then the ([beta]) process is started.

### PRIOR ART DOCUMENT

### PATENT DOCUMENT

Patent Document 1: JP-A-9-123387
Patent Document 2: JP-A-9-123388
Patent Document 3: JP-A-2004-314530
Patent Document 4: JP-A-2005-262636
Patent Document 5: JP-A-2005-088454

### DISCLOSURE OF THE INVENTION

### PROBLEMS THAT THE INVENTION IS TO SOLVE

An object of the invention is to provide a printing method using a lithographic printing plate precursor capable of undergoing on-press development, which is a simple printing method for improving on-press development property (that is, decreasing a number of waste sheets at the start of printing) and avoiding the occurrence of unevenness in printed materials.

### MEANS FOR SOLVING THE PROBLEMS

(1) A printing method of a lithographic printing plate precursor having on an aluminum support, an image-recording layer capable of being developed by supplying at least any of printing ink and dampening water, wherein steps (i) to (v) shown below are performed at start of printing in order of (i), (ii), (iii), (iv) and (v) or in order of (i), (iii), (ii), (iv) and (v):
   (i) exposing imagewise the lithographic printing plate precursor and then mounting on a plate cylinder of a printing machine;
   (ii) supplying by spraying at least any of dampening water and an aqueous solution containing an organic solvent to at least any of a dampening roller, a roller for supplying water to dampening roller, a roller for stabilizing water amount and a metering roller, which are dampening water supply means of the printing machine;
   (iii) rotating water feed rollers without being brought the dampening roller into contact with the lithographic printing plate precursor;
   (iv) bringing the dampening roller into contact with the lithographic printing plate precursor to supply dampening water from the dampening roller to the lithographic printing plate precursor;
   (v) bringing an inking roller into contact with the lithographic printing plate precursor to supply printing ink from the inking roller to the lithographic printing plate precursor, and supplying printing paper at the same time as or after the bringing an inking roller into contact with the lithographic printing plate precursor.
(2) The printing method as described in (1) above, wherein the steps of (i) to (v) at the start of printing is performed in order of (i), (ii), (iii), (iv) and (v), and after being rotated the water feed rollers from 1 to 50 rotations in step (iii), the dampening roller is brought into contact with the lithographic printing plate precursor.
(3) The printing method as described in (1) or (2) above, after bringing the dampening roller into contact with the lithographic printing plate precursor in step (iv) the contact is released once, and within 30 minutes after the releasing, the dampening roller is again brought into contact with the lithographic printing plate precursor.
(4) The printing method as described in any one of (1) to (3) above, wherein the organic solvent in the solution containing an organic solvent for injecting in step (ii) is a solvent miscible with water.
(5) The printing method as described in (4) above, wherein the organic solvent is an alcohol solvent, an ester solvent, an ether solvent or a ketone solvent.
(6) The printing method as described in any one of (1) to (3) above, wherein the dampening water for injecting in step (ii) has same composition as dampening water used during printing and has high concentration.
(7) The printing method as described in any one of (1) to (6) above, wherein the image-recording layer contains an infrared absorbing agent, a polymerization initiator, a radical polymerizable compound and a bonder polymer.
(8) The printing method as described in (8) above, wherein the binder polymer is an acrylic resin binder having polyethylene oxide or polypropylene oxide in its side chain.
(9) The printing method as described in any one of (1) to (8) above, wherein the lithographic printing plate precursor has an undercoat layer containing a polymer compound having a hydrophilic group and a group adsorbing to a surface of the support between the aluminum support and the image-recording layer.

### ADVANTAGE OF THE INVENTION

According to the invention, a simple printing method in which a number of waste sheets at the start of printing is decreased and which avoids the occurrence of unevenness in printed materials can be provided.

### BRIEF DESCRIPTION OF THE DRAWING

Fig. 1 is a schematic drawing of an Epic Delta water supply device.
Fig. 2 is a schematic drawing of an Al Color water supply device.
Fig. 3 is a schematic drawing of a Komorimatic water supply device.
Fig. 4 is a schematic drawing of a Komorimatic water supply device attached to a lithographic printing machine, Spica 26, produced by Komori Corp.

### MODE FOR CARRYING OUT THE INVENTION

Hereinafter, the printing method according to the invention and a lithographic printing plate precursor of on-press development type used in the printing method will be described. First, a dampening water supply mechanism and an ink supply mechanism of a printing machine involved in the printing method according to the invention will be described.

In the printing machine, a plurality of rollers (ink rollers and water feed rollers) for supplying ink and dampening water from respective supply sources to a plate cylinder are provided. The roller group comprises a drive roller which rotates itself by being transmitted a driving forth from a driving source and a driven roller which rotates by the rotation of the drive roller and is disposed adjacent to the drive roller.

The ink or dampening water on each roller is transferred in sequence to a peripheral surface of an adjacent roller to supply the ink and dampening water to the plate cylinder, and the ink is transferred from the plate cylinder to printing paper through a blanket cylinder, whereby printing of a picture is performed.

The water feed rollers are printing machine apparatus for transmitting and transporting dampening water by rotating in contact with each other in the printing machine, and constituted from a water pan roller, a dampening roller, a roller for supplying water to dampening roller, a metering roller and a roller for stabilizing water amount.

The water pan roller is constituted in such a manner that a part of the peripheral surface thereof is immersed in dampening water of a water pan (dampening water supply source storing the dampening water), and is a roller which transmits the dampening water in the water pan to a roller for supplying water to dampening roller or a metering roller by its rotation.

The roller for supplying water to dampening roller or the metering roller is a roller which transmits the dampening water supplied from the water pan roller to a dampening roller.

The dampening roller is a roller for supplying the dampening water supplied from the roller for supplying water to dampening roller or a roller for stabilizing water amount to a lithographic printing plate precursor mounted on a plate cylinder.

These rollers in the printing machine constitute a roller apparatus of the printing machine for transmitting and transporting the dampening water by rotating in contact with each other, and comprise a roller which has a cylindrical shape, the outer peripheral surface of which is made of a metal and which is rotatable in the peripheral direction and a roller which has a cylindrical shape, the outer peripheral surface of which is made of an elastic body and which is adjacent to the roller described above and rotatable dependent on the rotation of the roller described above in the peripheral direction.

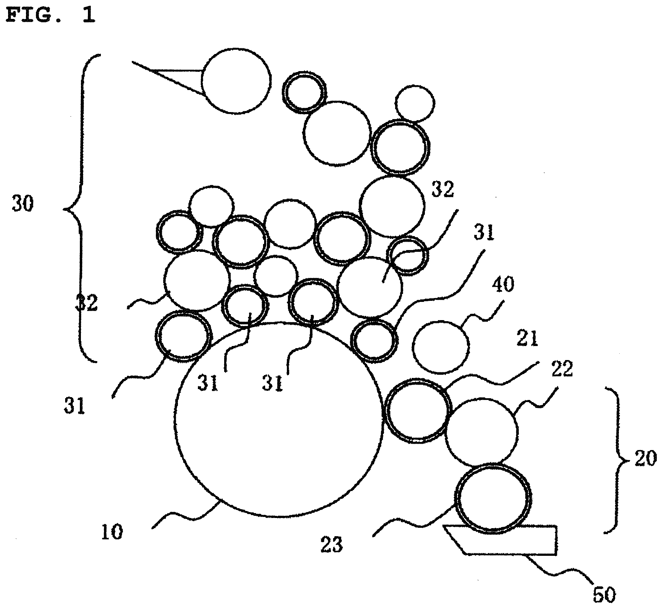

Fig. 1 to Fig. 4 show schematic drawings of examples of the water supply device which can be used in the practice of the printing method according to the invention.

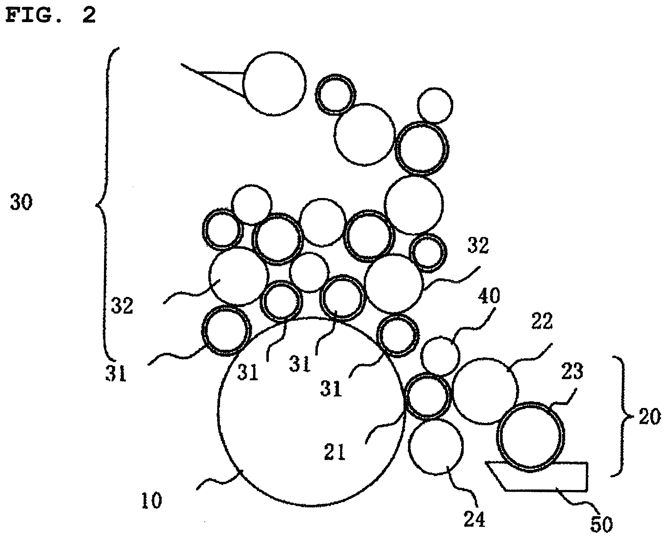

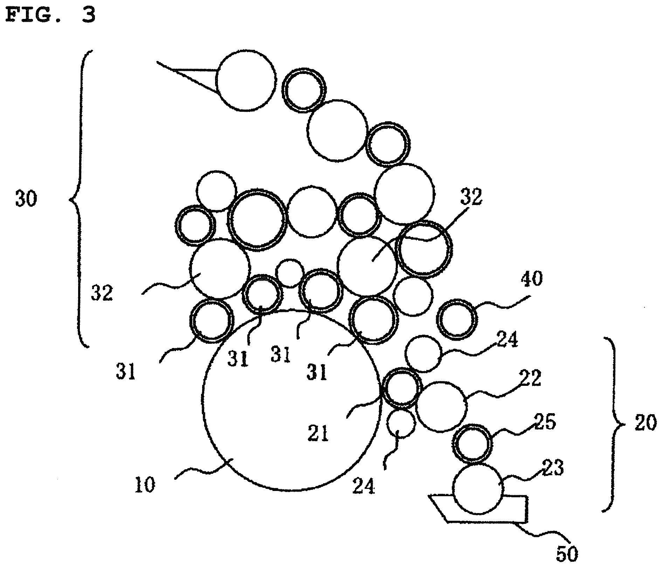

The water supply device shown in Fig. 1 is an Epic Delta water supply device. The water supply device shown in Fig. 2 is an Al Color water supply device. The water supply device shown in Fig. 1 is a Komorimatic water supply device. Any of the water supply devices has a dampening roller 21 in contact with a plate cylinder 10, a roller 22 for supplying dampening water from a water pan 50 to the dampening roller 21 in contact therewith, and a water pan roller 23 immerged in the dampening water in the water pan 50, as water feed rollers 20. Further, the water supply device has a roller 24 for stabilizing water amount of on the dampening roller 21 in contact with the dampening roller 21 in some cases. The roller 24 may also be referred to as a distribution roller, a rider roller or the like depending on the water supply system. Also, the water supply device may have a bridge roller 40 which makes an indirect water supply system by bridging the water feed rollers 20 to ink rollers 30 comprising an inking roller 31 and a distributing roller 32 thereon. When the bridge roller is present as shown in Fig. 3, printing ink may supply through the bridge roller to a lithographic printing plate precursor at the same time as dampening water. Further, in the printing method according to the invention, the bridge roller 40 is not brought into contact with at least one of the water feed rollers 20 and the ink rollers 30 and the dampening water may be supplied by a direct water supply system.

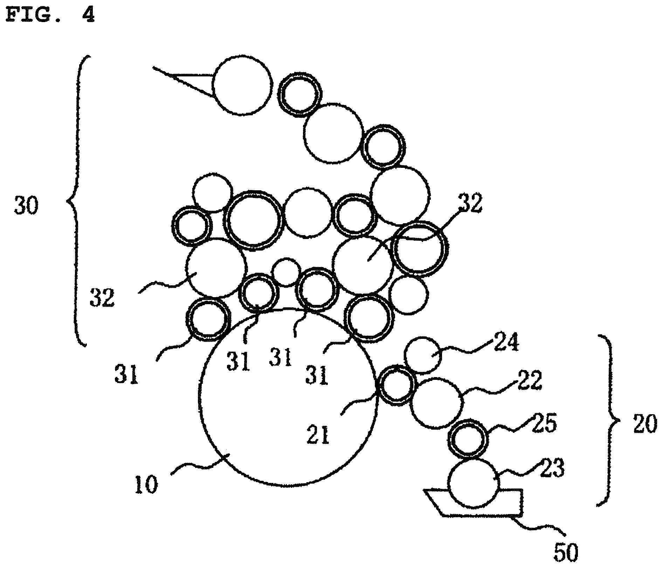

Although the water supply device shown in Fig. 4 is also a Komorimatic water supply device, it is a water supply device used exclusively for the direct water supply system in which the bridge roller 40 is eliminated from the Komorimatic water supply device shown in Fig. 3.

### [Printing method]

The printing method according to the invention is a printing method of a lithographic printing plate precursor having on an aluminum support, an image-recording layer capable of being developed by supplying at least any of printing ink and dampening water, wherein steps (i) to (v) shown below are performed at start of printing in order of (i), (ii), (iii), (iv) and (v) or in order of (i), (iii), (ii), (iv) and (v):
(i) exposing imagewise the lithographic printing plate precursor and then mounting on a plate cylinder of a printing machine;
(ii) supplying by spraying at least any of dampening water and an aqueous solution containing an organic solvent to at least any of a dampening roller, a roller for supplying water to dampening roller, a roller for stabilizing water amount and a metering roller, which are dampening water supply means of the printing machine;
(iii) rotating water feed rollers without being brought the dampening roller into contact with the lithographic printing plate precursor;
(iv) bringing the dampening roller into contact with the lithographic printing plate precursor to supply dampening water from the dampening roller to the lithographic printing plate precursor;
(v) bringing an inking roller into contact with the lithographic printing plate precursor to supply printing ink from the inking roller to the lithographic printing plate precursor, and supplying printing paper at the same time as or after the bringing an inking roller into contact with the lithographic printing plate precursor.

Hereinafter, each of the steps is described.

### <(i) Exposing imagewise the lithographic printing plate precursor and then mounting on a plate cylinder of a printing machine>

As a light source used for the image exposure in the invention, a laser is preferred. The laser for use in the invention is not particularly restricted and preferably includes, for example, a solid laser or semiconductor laser emitting an infrared ray having a wavelength from 760 to 1,200 nm.

With respect to the infrared ray laser, the output is preferably 100 mW or more, the exposure time per pixel is preferably within 20 microseconds, and the irradiation energy amount is preferably from 10 to 300 mJ/cm². With respect to the laser exposure, in order to reduce the exposure time, it is preferred to use a multibeam laser device.

The exposed lithographic printing plate precursor is mounted on a plate cylinder of a printing machine. In the case of using a printing machine equipped with a laser exposure apparatus, the lithographic printing plate precursor is mounted on a plate cylinder of the printing machine and then subjected to the image exposure.

### <(ii) Supplying by spraying at least any of dampening water and an aqueous solution containing an organic solvent to at least any of a dampening roller, a roller for supplying water to dampening roller, a roller for stabilizing water amount and a metering roller, which are dampening water supply means of the printing machine>

The supply by spraying means that dampening water or an aqueous solution containing an organic solvent is supplied by injection from a container or device having a spray injection mechanism by hand of printing operator to at least any of a dampening roller, a roller for supplying water to dampening roller, a roller for stabilizing water amount and a metering roller.

Among them, it is preferred to supply by spraying to at least any of the roller for supplying water to dampening roller and the metering roller.

The means for supplying by spraying is not particularly restricted and includes, for example, means for injecting from a container having a spray injection mechanism by hand of printing operator and means for injecting from a plurality of spray devices arranged in the printing width direction wherein an amount of liquid supplied in the printing width direction is controlled with respect to each of the spray devices.

Specific examples of the means for injecting by hand of printing operator include a household spray bottle (sprayer), a hand spray gun, an automatic spray gun, a portable sprayer and a washing bottle.

The amount of liquid injected is preferably from 2 to 200 ml/m², more preferably from 5 to 200 ml/m², based on a unit area of the lithographic printing plate precursor mounted. In the range described above, good on-press development property and dissolution of printing unevenness are achieved. The liquid temperature is preferably from 10 to 35°C, and particularly preferably from 15 to 25°C.

### <(iii) Rotating water feed rollers>

The water feed rollers are rotated without being brought the dampening roller into contact with the lithographic printing plate precursor. By means of the operation, the aqueous solution or dampening water injected in the step (ii) is uniformly spread in each of the water pan roller, the roller for supplying water to dampening roller and the dampening roller while mixing with dampening water supplied from a water pan.

As to the rotation, from 1 to 50 rotations is preferred, from 2 to 25 rotations is more preferred, from 3 to 20 rotations is most preferred, in terms of a rotation number of the dampening roller. When the rotation is not carried out, the liquid does not spread uniformly to cause unevenness in the development. The rotations exceeding 50 times tends to decrease the effect of injection. After temporarily stopping the rotation, the rotation may be again performed.

### <(iv) Bringing the dampening roller into contact with the lithographic printing plate precursor to supply dampening water from the dampening roller to the lithographic printing plate precursor>

By bringing the dampening roller into contact with the lithographic printing plate precursor, the liquid sprayed and the dampening water from the water pan are supplied to the lithographic printing plate precursor to penetrate into an image-recording layer. Due to the penetration of these aqueous solutions into the image-recording layer the cohesion force in the image-recording layer and the adhesion property between a support (an undercoat layer when the undercoat layer is present) and the image-recording layer are reduced.

A rotation number of the plate cylinder after bringing the dampening roller into contact with the surface of lithographic printing plate precursor until bringing an inking roller into contact with the surface of lithographic printing plate precursor is preferably from 0 to 50 rotations, more preferably from 1 to 25 rotations, and still more preferably from 2 to 10 rotations. The term 0 rotation as used herein means that the dampening roller and the inking roller may be brought into contact with the surface of lithographic printing plate precursor at the same time.

After bringing the plate cylinder into contact with the surface of lithographic printing plate precursor, the contact is released once, and it is again brought into contact with the surface of lithographic printing plate precursor. In this case, the first contact time of the dampening roller is preferably from 1 to 50 rotations, more preferably from 1 to 25 rotations, still more preferably from 1 to 10 rotations, in terms of rotation number of the plate cylinder. A time (waiting time) from the release of contact once to contacting again is preferably 30 minutes or less, more preferably from 3 to 10 minutes, and still more preferably from 5 to 8 minutes. A rotation number of the plate cylinder after again bringing the dampening roller into contact with the surface of lithographic printing plate precursor until bringing an inking roller into contact with the surface of lithographic printing plate precursor in next step (v) is preferably from 0 to 50 rotations, more preferably from 1 to 25 rotations, and still more preferably from 1 to 10 rotations. At the time when the dampening roller is again brought into contact with the surface of lithographic printing plate precursor, bringing the inking roller into contact with the surface of lithographic printing plate precursor in step (v) may be carried out at the same time.

In the case where after bringing the dampening roller into contact with the surface of lithographic printing plate precursor, the contact is released once, and it is again brought into contact with the surface of lithographic printing plate precursor, from the standpoint of decreasing waste sheets a combination is most preferred wherein the dampening roller is brought into contact with the surface of lithographic printing plate precursor, after rotating the plate cylinder from 1 to 10 rotations, the contact is released once; after waiting from 5 to 8 minutes as it is, the dampening roller is again brought into contact with the surface of lithographic printing plate precursor; and after bringing again the dampening roller into contact with the surface of lithographic printing plate precursor until bringing an inking roller into contact with the surface of lithographic printing plate precursor in next step (v), the plate cylinder is rotated from 1 to 10 rotations.

### <(v) Bringing an inking roller into contact with the lithographic printing plate precursor to supply printing ink from the inking roller to the lithographic printing plate precursor, and supplying printing paper at the same time as or after the bringing an inking roller into contact with the lithographic printing plate precursor>

The inking roller is brought into contact with the lithographic printing plate precursor to supply printing ink to the lithographic printing plate precursor, and further printing paper is supplied.

The supply of printing paper is carried out at the same time as or after the bringing the inking roller into contact with the lithographic printing plate precursor. In the invention, although the unexposed area of the image-recording layer is removed in a manner of dissolution or in a manner of stripping in some cases, it is preferred to be removed in the manner of stripping. In the case of removal in the manner of stripping, the unexposed area of the image-recording layer is removed in the manner of stripping by tack of the ink and the image-recording layer removed in the manner of stripping by tack of the ink is transferred to the paper.

According to the invention, as well as a first method wherein the steps of (i) to (v) is performed in the order of (i), (ii), (iii), (iv) and (v), a second method wherein the steps of (i) to (v) is performed in the order of (i), (iii), (ii), (iv) and (v) is also used. In the first method, after the step (ii) the rotation of the water feed rollers of the step (iii) is performed so that in comparison with the second method the damping water from the water pan is easily miscible with the liquid supplied by injection to achieve more homogenization of the liquid. Therefore, the order of (i), (ii), (iii), (iv) and (v) in the first method is preferred in view of reduction of the unevenness resulting from the unevenness of liquid.

### [Aqueous solution for supplying by spraying]

The aqueous solution for supplying by spraying includes dampening water or an aqueous solution containing an organic solvent. The organic solvent used in the aqueous solution containing an organic solvent is preferably water-soluble.

### [Description of the aqueous solution containing an organic solvent]

The organic solvent in the aqueous solution containing an organic solvent is preferably a solvent which is capable of dissolving or swelling the image-recording layer and is miscible with water (water-miscible solvent), and it is preferred to use as a mixture with water. A mixing ratio of the organic solvent and water is preferably from 80:20 to 5:95, more preferably from 70:30 to 10:90, most preferably from 60:40 to 20:80, in a volume ratio of organic solvent:water.

Examples of the organic solvent (water-miscible solvent) include an ester solvent, for example, methyl acetate, diethylene glycol monoethyl ether acetate, ethylene glycol monomethyl ether acetate, ethylene glycol monoethyl ether acetate or glycerol triacetate, an ether solvent, for example, ethyl ether, tetrahydrofuran or polyethylene glycol, a ketone solvent, for example, acetone or methyl ethyl ketone, an alcohol solvent, for example, isopropyl alcohol (IPA), isobutyl alcohol, 1-methoxy-2-propanol, 1-butanol, 2-butanol, methanol or ethanol, a glycol solvent, for example, ethylene glycol monoethyl ether, ethylene glycol monoethyl ether acetate, ethylene glycol mono-n-butyl ether, ethylene glycol monomethyl ether or propylene glycol monomethyl ether acetate, N,N-dimethylformamide and N-methyl-2-pyrrolidone, and the alcohol solvent, the ester solvent, the ether solvent or the ketone solvent is preferred.

Further, to the aqueous solution containing an organic solvent can be added a surfactant. As the surfactant, the surfactant added to the dampening water described below is exemplified.

An organic solvent which is ordinarily immiscible with water may be used by mixing with water using a surfactant.

### [Dampening water]

The dampening water which is used as the aqueous solution for supplying by spraying in the invention may be dampening water having the same composition as dampening water used during printing or dampening water having a different composition. The dampening water having the same composition as dampening water used during printing is preferred because the liquids easily adopt each other in step (iii). In the case of using the dampening water having the same composition, the concentration of the dampening water is not particularly restricted and the dampening water having higher concentration than the dampening water used during printing is preferably used.

The dampening water which is used as the aqueous solution for supplying by spraying in the invention may contain, in addition to a solvent, components described below.
(a) aid for improving wettability
(b) water-soluble polymer compound
(c) pH adjusting agent
(d) odor masking agent
(e) others ((i) preservative, (ii) chelating agent, (iii) coloring agent, (iv) antirust agent, (v) antifoam agent and the like)

The solvent for use in the dampening water includes solvents described, for example, in JP-A-2001-138659, JP-A-2001-180146, JP-A-2002-178661, JP-A-2002-187375, JP-A-2002-187376, JP-A-2002-192853, JP-A-2003-39847, JP-A-2003-170673, JP-A-2003-276357, JP-A-2003-285571, JP-A-2004-160869, JP-A-2004-174892, JP-A-2004-181632 and JP-A-2004-181858.

Specific examples thereof include propylene glycol monopropyl ether, dipropylene glycol monopropyl ether, tripropylene glycol monopropyl ether, propylene glycol monoisopropyl ether, dipropylene glycol monoisopropyl ether, tripropylene glycol monoisopropyl ether, propylene glycol monobutyl ether, dipropylene glycol monobutyl ether, tripropylene glycol monobutyl ether, propylene glycol monoisobutyl ether, dipropylene glycol monoisobutyl ether, tripropylene glycol monoisobutyl ether, propylene glycol monotertiarybutyl ether, dipropylene glycol monotertiarybutyl ether, tripropylene glycol monotertiarybutyl ether, propylene glycol mono-n-pentyl ether, dipropylene glycol mono-n-pentyl ether, propylene glycol monoisopentyl ether, dipropylene glycol monoisopentyl ether, propylene glycol mono-n-hexane ether, dipropylene glycol mono-n-hexane ether, dipropylene glycol monomethylpentyl ether and propylene glycol mono-2-ethylbutyl ether. The compounds may be used individually or in combination of two or more thereof.

Among them, propylene glycol monoisopropyl ether, propylene glycol mono-n-butyl ether, propylene glycol mono-tert-butyl ether, dipropylene glycol mono-n-butyl ether, dipropylene glycol mono-tert-butyl ether, propylene glycol mono-n-pentyl ether, propylene glycol mono-isopentyl ether and the like can be preferably used.

The content of the compound described above in the dampening water composition is suitably from 0.2 to 8% by weight, more preferably from 0.5 to 5% by weight, based on the total weight of the dampening water composition. In the range described above, good wettability of the dampening water to the surface of lithographic printing plate precursor is obtained without causing roller strip, poor printing durability of lithographic printing plate and the like.

As the aid for improving wettability (a), a surfactant or other solvents can be used. Of the surfactants, for instance, an anionic surfactant includes, for example, fatty acid salts, abietic acid salts, hydroxyalkanesulfonic acid salts, alkanesulfonic acid salts, dialkylsulfosuccinic acid salts, straight-chain alkylbenzenesulfonic acid salts, branched alkylbenzenesulfonic acid salts, alkylnaphthalenesulfonic acid salts, alkylphenoxy polyoxyethylene propylsulfonic acid salts, polyoxyethylene alkylsulfophenyl ether salts, N-methyl-N-oleyltaurine sodium salt, N-alkylsulfosuccinic acid monoamide disodium salts, petroleum sulfonic acid salts, sulfated castor oil, sulfated beef tallow oil, sulfate ester slats of fatty acid alkyl ester, alkyl sulfate ester salts, polyoxyethylene alkyl ether sulfate ester salts, fatty acid monoglyceride sulfate ester salts, polyoxyethylene alkyl phenyl ether sulfate ester salts, polyoxyethylene styryl phenyl ether sulfate ester salts, alkyl phosphate ester salts, polyoxyethylene alkyl ether phosphate ester salts, polyoxyethylene alkyl phenyl ether phosphate ester salts, partially saponified products of styrene-maleic anhydride copolymer, partially saponified products of olefin-maleic anhydride copolymer and naphthalene sulfonate formalin condensates. Of the compounds, dialkylsulfosuccinic acid salts, alkyl sulfate ester salts and alkylnaphthalenesulfonic acid salts are particularly preferably used.

A nonionic surfactant includes, for example, polyoxyethylene alkyl ethers, polyoxyethylene alkyl phenyl ethers, polyoxyethylene polystyryl phenyl ethers, polyoxyethylene polyoxypropylene alkyl ethers, glycerol fatty acid partial esters, sorbitan fatty acid partial esters, pentaerythritol fatty acid partial esters, propylene glycol mono fatty acid esters, sucrose fatty acid partial esters, polyoxyethylene sorbitan fatty acid partial esters, polyoxyethylene sorbitol fatty acid partial esters, polyethylene glycol fatty acid esters, polyglycerol fatty acid partial esters, polyoxyethylene castor oils, polyoxyethylene glycerol fatty acid partial esters, fatty acid diethanolamides, N,N-bis-2-hydroxyalkyl amines, polyoxyethylenealkylamines, triethanolamine fatty acid esters, polyoxypropylene-polyoxypropylene block polymers and trialkylamine oxides. In addition, a fluorine-based surfactant or a silicon-based surfactant can also be used. In the case of using the surfactant, the content thereof is 1% by weight or less, preferably from 0.001 to 0.5% by weight, taking into account bubble formation. The surfactants may be used in combination of two or more thereof.

In addition, the aid for improving wettability includes ethylene glycol monomethyl ether, diethylene glycol monomethyl ether, triethylene glycol monomethyl ether, tetraethylene glycol monomethyl ether, ethylene glycol monoethyl ether, diethylene glycol monoethyl ether, triethylene glycol monoethyl ether, tetraethylene glycol monoethyl ether, ethylene glycol monopropyl ether, diethylene glycol monopropyl ether, triethylene glycol monopropyl ether, tetraethylene glycol monopropyl ether, ethylene glycol monoisopropyl ether, diethylene glycol monoisopropyl ether, triethylene glycol monoisopropyl ether, tetraethylene glycol monoisopropyl ether,
ethyleneglycol monobutyl ether, ethylene glycol monotertiarybutyl ether, diethylene glycol monobutyl ether, triethylene glycol monobutyl ether, tetraethylene glycol monobutyl ether, ethylene glycol monoisobutyl ether, diethylene glycol monoisobutyl ether, triethylene glycol monoisobutyl ether, tetraethylene glycol monoisobutyl ether, ethylene glycol monotertarybutyl ether, diethylene glycol monotertarybutyl ether, triethylene glycol monotertarybutyl ether, tetraethylene glycol monotertarybutyl ether,
ethylene glycol, diethylene glycol, triethylene glycol, butylene glycol, hexylene glycol, 2-ethyl-1,3-hexanediol, 3-methoxy-3-methyl-1-butanol, 1-butoxy-2-propanol, glycerol, diglycerol, polyglycerol, trimethylolpropane and a 2-pyrrolidone derivative 1-position of which is substituted with an alkyl group having from 1 to 8 carbon atoms. Of the compounds, ethylene glycol monotertiarybutyl ether and 3-methoxy-3-methyl-1-butanol are preferred. The solvents may be used individually or in combination of two or more thereof. In general, the solvent is suitably used in a range from 0.02 to 1% by weight, preferably from 0.05 to 0.5% by weight, based on the total weight of the dampening water.

The water-soluble polymer compound (b) used in the dampening water for use in the invention includes, for instance, a natural product and a modified product thereof, for example, gum arabic, a starch derivative (for example, dextrin, enzyme-decomposed dextrin, hydroxypropylated enzyme-decomposed dextrin, carboxymethylated starch, phosphoric acid starch or octenylsuccinated starch), an alginate or a cellulose derivative (for example, carboxymethyl cellulose, carboxyethyl cellulose, methyl cellulose or hydroxyethyl cellulose), a synthetic product, for example, polyethylene glycol and a copolymer thereof, polyvinyl alcohol and a derivative thereof, polyacrylamide and a copolymer thereof, polyacrylic acid and a copolymer thereof, a vinyl methyl ether/maleic anhydride copolymer, a vinyl acetate/maleic anhydride copolymer or polystyrene sulfonic acid and a copolymer thereof, and polyvinyl pyrrolidone. Of the compounds, carboxymethyl cellulose and hydroxyethyl cellulose are particularly preferred. The content of the water-soluble polymer compound is suitably from 0.001 to 0.5% by weight, more preferably from 0.005 to 0.2% by weight, based on the dampening water.

As the pH adjusting agent (c) used in the dampening water for use in the invention, at least one selected from a water-soluble organic acid, inorganic acid and salts thereof is employed. The compound is effective for pH adjustment or pH buffering of the dampening water, or appropriate etching or corrosion prevention of support of lithographic printing plate. Preferred examples of the organic acid include citric acid, ascorbic acid, malic acid, tartaric acid, lactic acid, acetic acid, gluconic acid, hydroxyacetic acid, oxalic acid, malonic acid, levulinic acid, sulfanilic acid, p-toluenesulfonic acid, phytic acid and an organic phosphonic acid. Examples of the inorganic acid include phosphoric acid, nitric acid, sulfuric acid and polyphosphoric acid. Further, alkali metal salts, alkaline earth metal salts, ammonium salts and organic amine salts of the organic acid or inorganic acid are also preferably used. The organic acid, inorganic acid and salts thereof may be used individually or as a mixture of two or more thereof

The addition amount of the pH adjacent agent to the dampening water is suitably in a range from 0.001 to 0.1% by weight in the total of the organic acid, inorganic acid and salts thereof When it is 0.001% by weight or more, due to etching force of aluminum which is the support of lithographic printing plate stain during printing is good. On the other hand, when it is 0.1% by weight or less, it is preferred in view of rust of printing machine. Although the dampening water is preferably used in an acidic region of a pH range from 3 to 7, it may also be used in an alkaline region of a pH range from 7 to 11 containing an alkali metal hydroxide, an alkali metal phosphate, an alkali metal carbonate, a silicate or the like.

The odor masking agent (d) includes an ester which is conventionally known as a perfume. For instance, a compound represented by formula (I) shown below is exemplified.

R₁-COOR₂ (I)

In the compound represented by formula (I), R₁ represents an alkyl group having from 1 to 15 carbon atoms, an alkenyl group, an aralkyl group or a phenyl group. In the case of the alkyl group or alkenyl group, a number of carbon atoms is preferably from 4 to 8. In the case where R₁ represents the alkyl group, alkenyl group or aralkyl group, it may be a straight-chain or branched. As the alkenyl group, that having one double bond is particularly suitable. As the aralkyl group, a benzyl group and a phenethyl group are exemplified. One or more hydrogen atoms of the alkyl group, alkenyl group, aralkyl group or phenyl group represented by R₁ may be substituted with a hydroxy group or an acetyl group. R₂ represents an alkyl group having from 3 to 10 carbon atoms, an aralkyl group or a phenyl group, which may be a straight-chain or branched. In the case of the alkyl group, a number of carbon atoms is preferably from 3 to 9. As the aralkyl group, a benzyl group and a phenethyl group are exemplified.

Specific examples of the odor masking agent (d) which can be used include an ester of formic acid, acetic acid, propionic acid, butyric acid, isobutyric acid, 2-ethylbutyric acid, valeric acid, isovaleric acid, 2-methylvaleric acid, hexanoic acid (caproic acid), 4-methylpentanoic acid (isohexanoic acid), 2-hexenoic acid, 4-pentenoic acid, heptanoic acid, 2-methylheptanoic acid, octanoic acid (caprylic acid), nonanoic acid, decanoic acid (capric acid), 2-decenic acid, lauric acid or myristic acid. In addition, an acetoacetate, for example, benzyl phenylacetate, ethyl acetoacetate or 2-hexyl acetoacetate is also used. Of the compounds, n-pentyl acetate, isopentyl acetate, n-butyl butyrate, n-pentyl butyrate and isopentyl butyrate are preferred, and n-butyl butyrate, n-pentyl butyrate and isopentyl butyrate are particularly preferred. The content of the odor masking agent (d) in the dampening water is suitably from 0.001 to 0.5% by weight, more preferably from 0.002 to 0.2% by weight, based on the total weight of the dampening water. By using the odor masking agent (d), working environment can be further improved. Also, vanillin, ethyl vanillin or the like may be used together.

Examples of the preservative (e) (i) used in the dampening water for use in the invention include phenol or a derivative thereof, formalin, an imidazole derivative, sodium dehydroacetate, a 4-isothiazolin-3-one derivative, a benzotriazole derivative, an amidine or guanidine derivative, a quaternary ammonium salt, a derivative of pyridine, quinoline or guanidine, a derivative of diazine or triazole, a derivative of oxazole or oxazine, a bromonitroalcohol, for example, bromonitropropanol, 1,1-dibromo-1-nitro-2-ethanol or 3-bromo-3-nitropentane-2,4-diol. A preferred addition amount is an amount for stably exerting the effect on bacteria, molds, yeasts and the like and varied depending on the kind of bacteria, molds or yeasts, and a range from 0.001 to 0.5 % by weight based on the dampening water is preferred. Also, it is preferred to use two or more kinds of the preservatives effective to various bacteria, molds or yeasts together.

The dampening water for use in the invention may further contain the chelating agent (e) (ii). The dampening water is ordinarily prepared by diluting a dampening water concentrate composition by adding tap water, well water or the like, and a calcium ion or the like included in the tap water or well water used for the dilution adversely affects printing to easily cause stain on the printed materials. In such a case, the drawback can be solved by adding the chelating agent to the dampening water. Preferred examples of the chelating agent include an organic phosphonic acid or phosphonoalkanetricarboxylic acid, for example, ethylenediaminetetraacetic acid, potassium salt thereof, sodium salt thereof; diethylenetriaminepentaacetic acid, potassium salt thereof, sodium salt thereof; triethylenetetraminehexaacetic acid, potassium salt thereof, sodium salt thereof; hydroxyethylethylenediaminetriacetic acid, potassium salt thereof, sodium salt thereof; nitrilotriacetic acid, sodium salt thereof; 1-hydroxyethane-1,1-diphosphonic acid, potassium salt thereof, sodium salt thereof; aminotri(methylenephosphonic acid), potassium salt thereof and sodium salt thereof. In place of the sodium salt or potassium salt of the chelating agent described above, an organic amine salt is also effectively used. The content of the chelating agent in the dampening water in use is suitably from 0.0001 to 0.5% by weight, and preferably from 0.0005 to 0.2% by weight.

The coloring agent (e) (iii) used in the dampening water for use in the invention preferably includes dyes for food. Examples of the coloring agent include a yellow dye, for example, C.I. Nos. 19140 and 15985, a red dye, for example, C.I. Nos. 16185, 45430, 16255, 45380 and 45100, a purple dye, for example, C.I. No. 42640, a blue dye, for example, C.I. Nos. 42090 and 73015, and a green dye, for example, C.I. No. 42095. The antirust agent (e) (iv) used in the dampening water for use in the invention includes benzotriazole, 5-methylbenzotriazole, thiosalicylic acid, benzimidazole and derivatives thereof. The antifoam agent (e) (v) used in the dampening water for use in the invention preferably includes a silicone antifoaming agent. Any of emulsion dispersion type and solubilized type silicone antifoaming agents can be used.

As the dampening water used for the aqueous solution supplied by spraying according to the invention, commercially available dampening water for lithographic printing can also be used. The commercially available dampening water is ordinarily sold as a concentrate and the concentrate is used as it is or it is appropriately diluted with water to use.

Examples of the commercially available dampening water include ECOLITY-2 and ECOLITY-W1 available from FUJIFILM Corp., ASTRO MARK 3 available from Nikken Chemical Laboratory Co., Ltd., CDS-709 available from Tokyo Printing Ink Mfg. Co., Ltd., and SOLAIA 503 available from Koyo Chemicals Inc.

### [Lithographic printing plate precursor of on-press development type]

The lithographic printing plate precursor for use in the invention is a lithographic printing plate precursor of on-press development type and it is preferred to have on an aluminum support, a radical polymerization type image-recording layer capable of being removed with at least one of dampening water and printing ink. Also, the lithographic printing plate precursor for use in the invention preferably has an undercoat layer containing a polymer compound having a hydrophilic group and a group adsorbing to a surface of the support between the aluminum support and the radical polymerization type image-recording layer. Further, the lithographic printing plate precursor according to the invention preferably has protective layer having an oxygen-blocking property on the image-recording layer.

Hereinafter, the elements, components and the like of the lithographic printing plate precursor for use in the invention are described.

A ratio of repeating units in the polymer in the description below is expressed as a molar ratio.

### (Image-recording layer)

The image-recording layer according to the invention is preferably a radical polymerization type image-recording layer. Also, the image-recording layer preferably contains an infrared absorbing dye, a radical polymerizable compound, a polymerization initiator and a binder polymer. The binder polymer is preferably an acrylic resin binder having polyethylene oxide or polypropylene oxide in its side chain in order to improve film characteristic and on-press development property of the image-recording layer.

### [Acrylic resin having polyethylene oxide or polypropylene oxide in its side chain]

The acrylic resin having polyethylene oxide or polypropylene oxide in its side chain for use in the invention is preferably a polymer having an ether group represented by formula (II) shown below in its side chain. Also, the acrylic resin having polyethylene oxide or polypropylene oxide in its side chain is suitable for the printing method according to the invention because it has high solubility in a solvent so that the solvent used in mixture with water in the invention can accelerate water permeability and stripping development property.

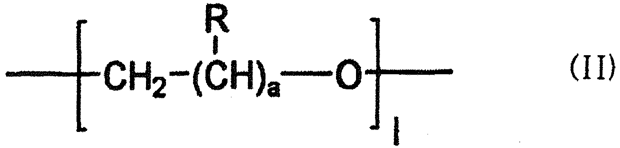

In formula (II), R represents a hydrogen atom or a methyl group, a represents 1, and 1 represents an integer from 2 to 120. 1 is preferably an integer from 2 to 60, more preferably an integer from 2 to 50, and still more preferably an integer from 2 to 20.

The binder polymer according to the invention may be copolymerized with a radical polymerizable compound having a hydrophilic group in order to improve various performances, for example, on-press development property. It is preferred that the hydrophilic group is not an alkali-soluble group, and the hydrophilic group includes, for example, an amido group, a hydroxy group and an onium salt group and is preferably an amido group or a hydroxy group. Specific examples of the radical polymerizable compound having a hydrophilic group include acrylamide, methacrylamide, N,N-dimethylacrylamide, N-isopropylacrylamide, N-vinylpyrrolidone, N-vinylacetamide, N-acryloylmorpholine, 2-hydroxyethyl acrylate and 2-hydroxyethyl methacrylate. The radical polymerizable compound having a hydrophjilic group may be used one or one or more kinds. The content of the copolymerization component is preferably from 0 to 85% by mole and particularly preferably from 5 to 70% by mole.

It is also a preferred embodiment of the binder polymer according to the invention to further copolymerize other radical polymerizable compound in addition to the radical polymerizable compound described above as long as the effect of the invention is not impaired for the purpose of various performances, for example, image strength. The radical polymerizable compound capable of being copolymerized with the binder polymer in the invention include a radical polymerizable compound selected from an acrylic acid ester, a methacrylic acid ester, an N,N-disubstituted acrylamide, an N,N-disubstituted methacrylamide, a styrene, an acrylonitrile, a methacrylonitrile and the like.

Specifically, for instance, an acrylic acid ester, for example, an alkyl acrylate (preferably having from 1 to 20 carbon atoms in the alkyl group thereof, for example, methyl acrylate, ethyl acrylate, propyl acrylate, butyl acrylate, amyl acrylate, ethylhexyl acrylate, octyl acrylate, tert-octyl acrylate, chloroethyl acrylate, 2,2-dimethylhydroxypropyl acrylate, 5-hydroxypentyl acrylate, trimethylolpropane monoacrylate, pentaerythritol monoacrylate, glycidyl acrylate, benzyl acrylate, methoxybenzyl acrylate, furfuryl acrylate or tetrahydrofurfuryl acrylate) or an aryl acrylate (for example, phenyl acrylate), a methacrylic acid ester, for example, an alkyl methacrylate (preferably having from 1 to 20 carbon atoms in the alkyl group thereof, for example, methyl methacrylate, ethyl methacrylate, propyl methacrylate, isopropyl methacrylate, amyl methacrylate, hexyl methacrylate, cyclohexyl methacrylate, benzyl methacrylate, chlorobenzyl methacrylate, octyl methacrylate, 4-hydroxybutyl methacrylate, 5-hydroxypentyl methacrylate, 2,2-dimethyl-3-hydroxypropyl methacrylate, trimethylolpropane monomethacrylate, pentaerythritol monomethacrylate, glycidyl methacrylate, furfuryl methacrylate or tetrahydrofurfuryl methacrylate) or an aryl methacrylate (for example, phenyl methacrylate, cresyl methacrylate or naphthyl methacrylate), styrene, a styrene derivative, for example, an alkylstyrene (for example, methylstyrene, dimethylstyrene, trimethylstyrene, ethylstyrene, diethylstyrene, isopropylstyrene, butylstyrene, hexylstyrene, cyclohexylstyrene, decylstyrene, benzylstyrene, chloromethylstyrene, trifluoromethylstyrene, ethoxymethylstyrene or acetoxymethylstyrene), an alkoxystyrene (for example, methoxystyrene, 4-methoxy-3-methylstyrene or dimethoxystyrene) or a halogenostyrene (for example, chlorostyrene, dichlorostyrene, trichlorostyrene, tetrachlorostyrene, pentachlorostyrene, bromostyrene, dibromostyrene, iodostyrene, fluorostyrene, trifluorostyrene, 2-bromo-4-trifluoromethylstyrene or 4-fluoro-3-trifluoromethylstyrene), acrylonitrile and methacrylonitrile are exemplified.

Of the radical polymerizable compounds, an acrylic acid ester, a methacrylic acid ester and a styrene are preferably used. The radical polymerizable compound may be used one kind or two or more kinds. The content of the copolymerization component is preferably from 0 to 95% by mole and particularly preferably from 20 to 90% by mole.

The binder polymer may have a crosslinking property in order to improve the film strength of the image area. In order to impart the crosslinking property to the binder polymer, a crosslinkable functional group, for example, an ethylenically unsaturated bond is introduced into a main chain or a side chain, preferably into a side chain, of the polymer. The crosslinkable functional group may be introduced by copolymerization.

Examples of the polymer having an ethylenically unsaturated bond in the side chain thereof include a polymer of an ester or amide of acrylic acid or methacrylic acid, which is a polymer wherein the ester or amido residue (R in -COOR or -CONHR) has an ethylenically unsaturated bond.

Examples of the residue (R described above) having an ethylenically unsaturated bond include -(CH₂)ₙCR¹=CR²R³, -(CH₂O)ₙCH₂CR¹=CR²R³, -(CH₂CH₂O)ₙCH₂CR¹=CR²R³, -(CH₂)ₙNH-CO-O-CH₂CR¹=CR²R³, -(CH₂)ₙ-O-CO-CR¹=CR²R³ and -(CH₂CH₂O)₂-X (wherein R¹ to R³ each represents a hydrogen atom, a halogen atom or an alkyl group having from 1 to 20 carbon atoms, an aryl group, an alkoxy group or an aryloxy group, or R¹ and R² or R¹ and R³ may be combined with each other to form a ring. n represents an integer from 1 to 10. X represents a dicyclopentadienyl residue).

Specific examples of the ester residue include -CH₂CH=CH₂ (described in JP-B-7-21633), -CH₂CH₂O-CH₂CH=CH₂, -CH₂C(CH₃)=CH₂, -CH₂CH=CH-C₆H₅, -CH₂CH₂OCOCH=CH-C₆H₅, -CH₂CH₂-NHCOO-CH₂CH=CH₂ and -CH₂CH₂O-X (wherein X represents a dicyclopentadienyl residue).

Specific examples of the amido residue include -CH₂CH=CH₂, -CH₂CH₂-Y (wherein Y represents a cyclohexene residue) and -CH₂CH₂-OCO-CH=CH₂.

The binder polymer having crosslinking property is cured, for example, by addition of a free radical (a polymerization initiating radical or a growing radical of a polymerizable compound in the process of polymerization) to the crosslinkable functional group of the polymer and undergoing addition polymerization between the polymers directly or through a polymerization chain of the polymerizable compound to form crosslinkage between the polymer molecules. Alternately, it is cured by generation of a polymer radical upon extraction of an atom (for example, a hydrogen atom on a carbon atom adjacent to the functional crosslinkable group) in the polymer by a free radial and connecting the polymer radicals with each other to form cross-linkage between the polymer molecules.

The content of the crosslinkable group (content of the radical polymerizable unsaturated double bond determined by iodine titration) in the binder polymer is preferably from 0.1 to 10.0 mmol, more preferably from 1.0 to 7.0 mmol, most preferably from 2.0 to 5.5 mmol, based on 1 g of the polymer. In the range described above, good sensitivity and good preservation stability can be obtained.

The binder polymer according to the invention may be a homopolymer or a copolymer of one or more kinds of the radical polymerizable compounds having the group represented by formula (II) and one or more kinds of the other radical polymerizable compounds described above, and in the latter case, the copolymer may be any of a block copolymer, a random copolymer and a graft copolymer.

The weight average molecular weight (Mw) of the binder polymer according to the invention is preferably 2,000 or more, and more preferably in a range from 5,000 to 300,000. The binder polymer according to the invention may contain an unreacted monomer. In this case, a ratio of the unreacted monomer in the binder polymer is desirably 15% by weight or less.

The content of the binder polymer in the image-recording layer according to the invention is preferably from about 5 to 95% by weight, more preferably from about 10 to 85% by weight, in terms of solid content. In the range described above, good strength in the image area and good image-forming property are obtained.

Specific examples of the binder polymer according to the invention are set forth below, but the invention should not be construed as being limited thereto.

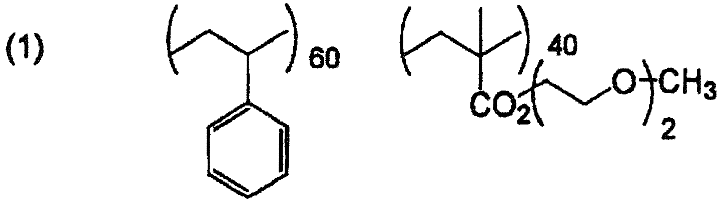

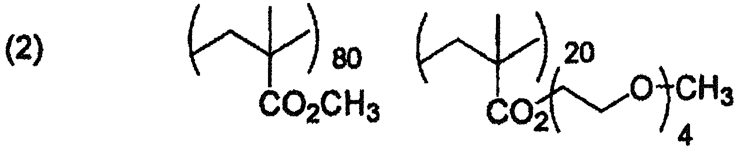

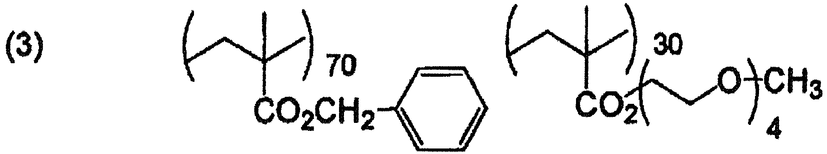

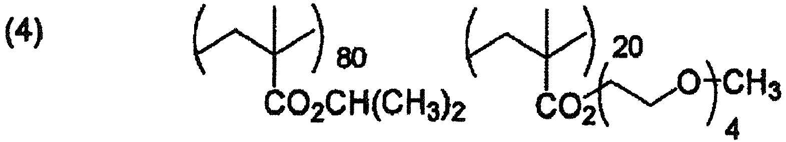

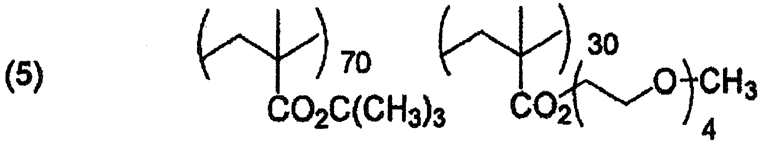

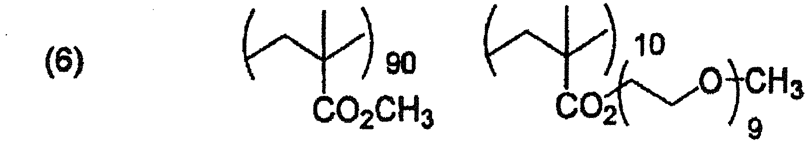

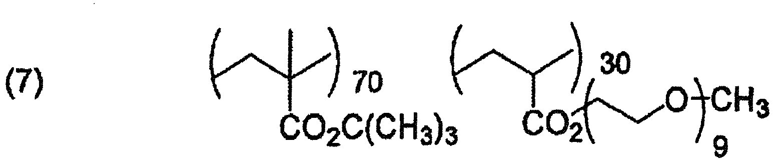

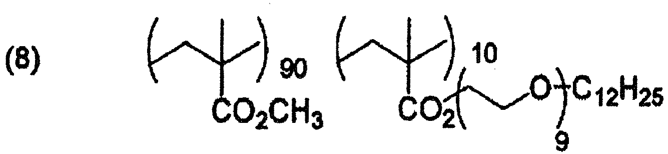

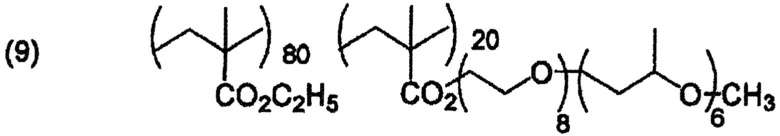

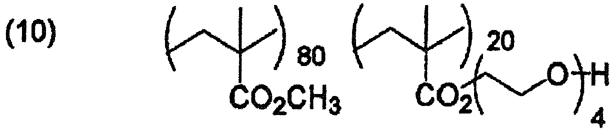

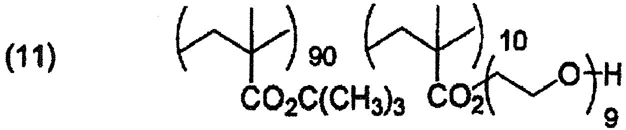

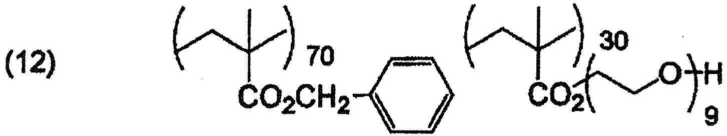

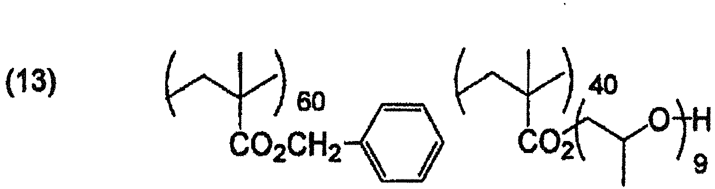

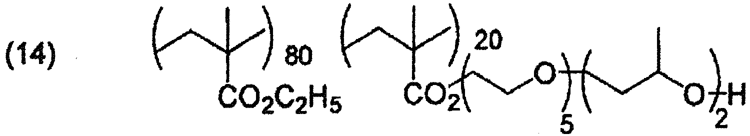

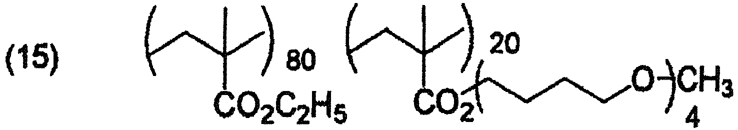

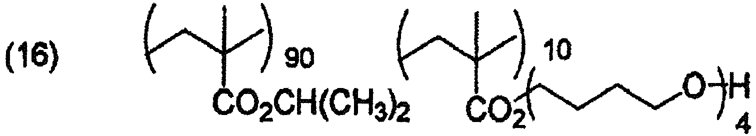

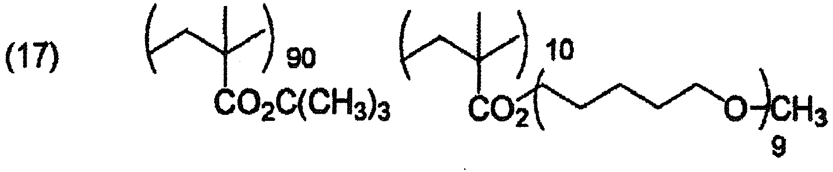

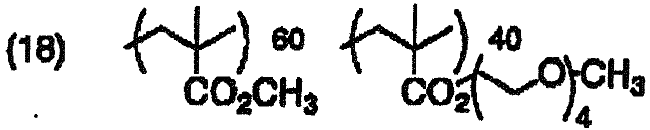

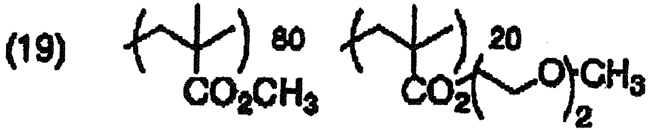

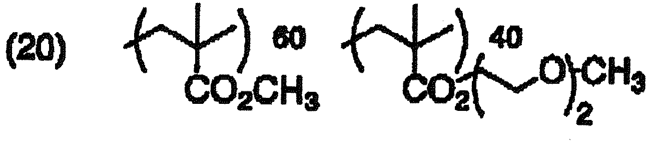

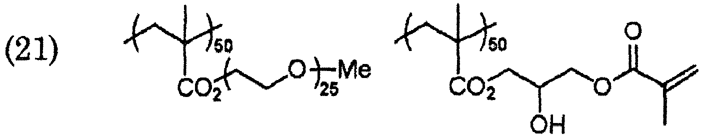

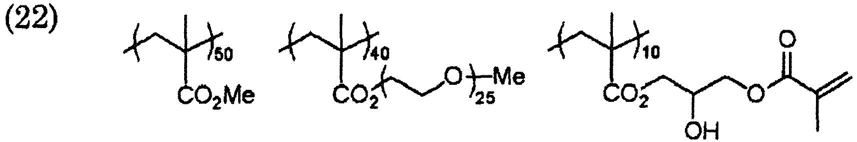

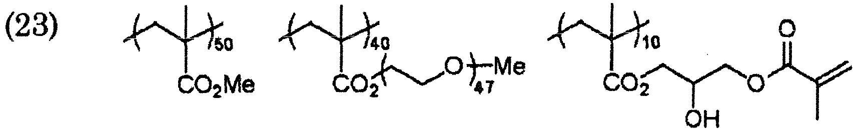

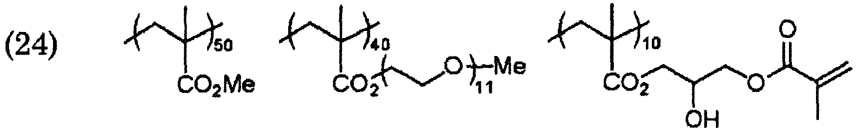

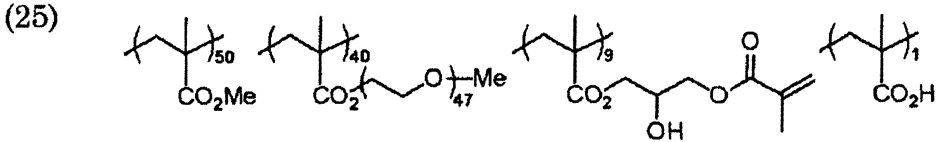

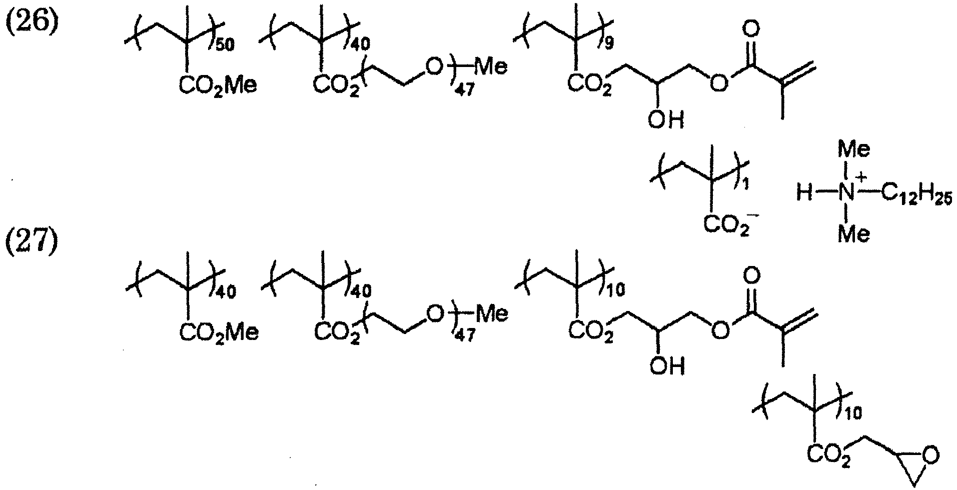

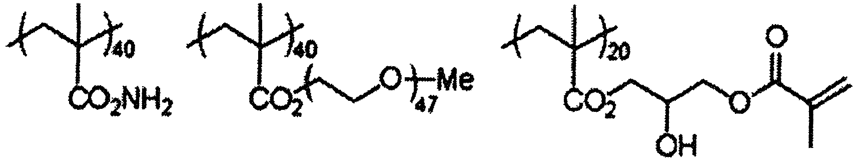

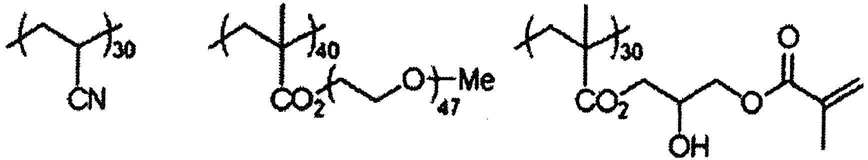

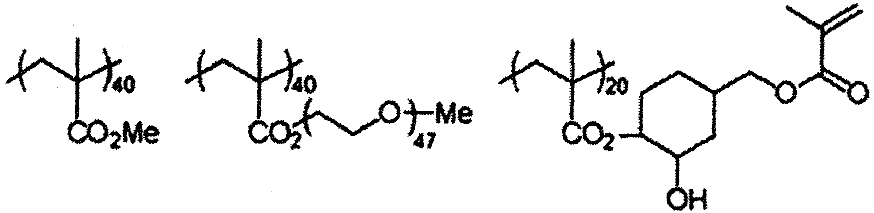

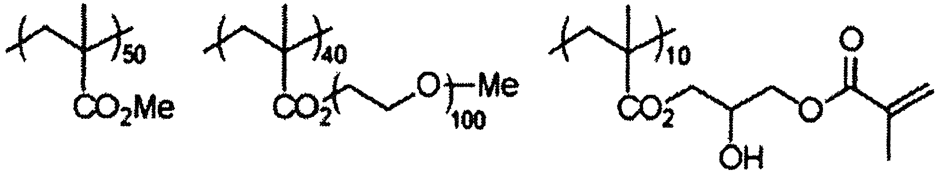

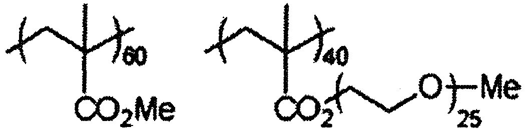

### [Infrared absorbing dye]

The infrared absorbing dye has a function of converting the infrared ray absorbed to heat and a function of being excited by the infrared ray to perform at least one of electron transfer and energy transfer to the polymerization initiator described below. The infrared absorbing dye for use in the invention includes a dye having an absorption maximum in a wavelength range from 760 to 1,200 nm.

As the dye, commercially available dyes and known dyes described in literatures, for example, Senryo Binran, compiled by The Society of Synthetic Organic Chemistry, Japan (1970) can be used. Specifically, the dye includes an azo dye, a metal complex azo dye, a pyrazolone azo dye, a naphthoquinone dye, an anthraquinone dye, a phthalocyanine dye, a carbonium dye, a quinoneimine dye, a methine dye, a cyanine dye, a squarylium dye, a pyrylium salt and a metal thiolate complex.

Of the dyes, a cyanine dye, a squarylium dye, a pyrylium salt, a nickel thiolate complex or an indolenine cyanine dye is particularly preferred. A cyanine dye or an indolenine cyanine dye is more preferred. As a particularly preferred example of the dye, a cyanine dye represented by formula (a) shown below is exemplified.

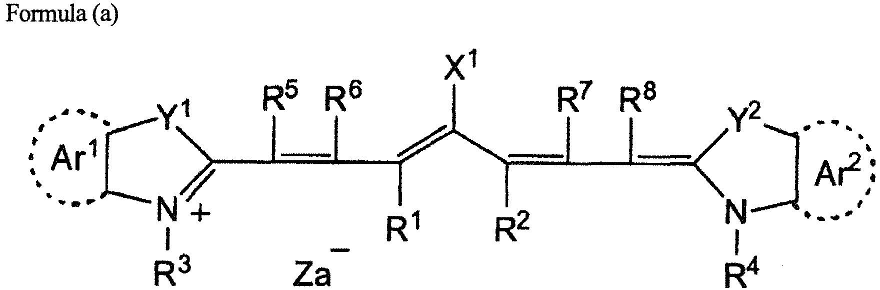

In formula (a), X¹ represents a hydrogen atom, a halogen atom, -N(R⁹)(R¹⁰), -X²-L¹ or a group shown below. R⁹ and R¹⁰, which may be the same or different, each represents an aromatic hydrocarbon group having from 6 to 10 carbon atoms which may have a substituent, an alkyl group having from 1 to 8 carbon atoms which may have a substituent or a hydrogen atom, or R⁹ and R¹⁰ may be combined with each other to form a ring. R⁹ and R¹⁰ each preferably represents a phenyl group. X² represents an oxygen atom or a sulfur atom. L¹ represents a hydrocarbon group having from 1 to 12 carbon atoms, an aromatic ring group containing a hetero atom or a hydrocarbon group having from 1 to 12 carbon atoms and containing a hetero atom. The hetero atom used herein indicates a nitrogen atom, a sulfur atom, an oxygen atom, a halogen atom or a selenium atom. In the group shown below, Xa⁻ has the same meaning as Za⁻ defined hereinafter. R^{a} represents a hydrogen atom or a substituent selected from an alkyl group, an aryl group, a substituted or unsubstituted amino group and a halogen atom.

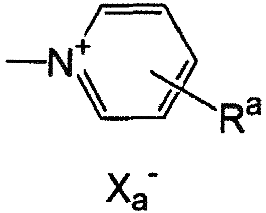

R¹ and R² each independently represents a hydrocarbon group having from 1 to 12 carbon atoms. In view of the preservation stability of a coating solution for image-recording layer, it is preferred that R¹ and R² each represents a hydrocarbon group having two or more carbon atoms. Alternatively, R¹ and R² may be combined with each other to form a ring and in the case of forming a ring, it is particularly preferred that R¹ and R² are combined with each other to form a 5-membered or 6-membered ring.

Ar¹ and Ar², which may be the same or different, each represents an aryl group which may have a substituent. Preferred examples of the aryl group include a benzene ring group and a naphthalene ring group. Preferred examples of the substituent include a hydrocarbon group having 12 or less carbon atoms, a halogen atom and an alkoxy group having 12 or less carbon atoms. Y¹ and Y², which may be the same or different, each represents a sulfur atom or a dialkylmethylene group having 12 or less carbon atoms. R³ and R⁴, which may be the same or different, each represents a hydrocarbon group having 20 or less carbon atoms which may have a substituent. Preferred examples of the substituent include an alkoxy group having 12 or less carbon atoms, a carboxylic acid group and a sulfonic acid group. R⁵, R⁶, R⁷ and R⁸, which may be the same or different, each represents a hydrogen atom or a hydrocarbon group having 12 or less carbon atoms. In view of the availability of raw materials, a hydrogen atom is preferred. Za⁻ represents a counter anion. However, Za⁻ is not necessary when the cyanine dye represented by formula (a) has an anionic substituent in the structure thereof and neutralization of charge is not needed. Preferred examples of the counter ion for Za⁻ include a halide ion, a perchlorate ion, a tetrafluoroborate ion, a hexafluorophosphate ion and a sulfonate ion, and particularly preferred examples thereof include a perchlorate ion, a hexafluorophosphate ion and an arylsulfonate ion in view of the preservation stability of a coating solution for image-recording layer.

Specific examples of the cyanine dye represented by formula (a), which can be preferably used in the invention, include compounds described in Paragraph Nos. [0017] to [0019] of JP-A-2001-133969, Paragraph Nos. [0012] to [0021] of JP-A-2002-23360 and Paragraph Nos. [0012] to [0037] of JP-A-2002-40638, preferably compounds described in Paragraph Nos. [0034] to [0041] of JP-A-2002-278057 and Paragraph Nos. [0080] to [0086] of JP-A-2008-195018, and most preferably compounds described in Paragraph Nos. [0035] to [0043] of JP-A-2007-90850.

Also, compounds described in Paragraph Nos. [0008] to [0009] of JP-A-5-5005 and Paragraph Nos. [0022] to [0025] of JP-A-2001-222101 are preferably used.

The infrared absorbing dye (A) may be used only one kind or in combination of two or more kinds thereof and it may also be used together with an infrared absorbing agent other than the infrared absorbing dye, for example, a pigment. As the pigment, compounds described in Paragraph Nos. [0072] to [0076] of JP-A-2008-195018 are preferred.

The content of the infrared absorbing dye in the image-recording layer according to the invention is preferably from 0.1 to 10.0% by weight, more preferably from 0.5 to 5.0% by weight, based on the total solid content of the image-recording layer.

### [Polymerization initiator]

The polymerization initiator which can be used in the invention indicates a compound which initiates or accelerates polymerization of a polymerizable compound. The polymerization initiator usable in the invention is preferably a radical polymerization initiator and, for example, known thermal polymerization initiators, compounds containing a bond having small bond dissociation energy and photopolymerization initiators can be used.

The polymerization initiator according to the invention include, for example, (a) an organic halide, (b) a carbonyl compound, (c) an azo compound, (d) an organic peroxide, (e) a metallocene compound, (f) an azide compound, (g) a hexaarylbiimidazole compound, (h) an organic borate compound, (i) a disulfone compound, (j) an oxime ester compound and (k) an onium salt compound.

As the organic halide (a), compounds described in Paragraph Nos. [0022] to [0023] of JP-A-2008-195018 are preferred.

As the carbonyl compound (b), compounds described in Paragraph No. [0024] of JP-A-2008-195018 are preferred.

As the azo compound (c), for example, azo compounds described in JP-A-8-108621 can be used.

As the organic peroxide (d), for example, compounds described in Paragraph No. [0025] of JP-A-2008-195018 are preferred.

As the metallocene compound (e), for example, compounds described in Paragraph No. [0026] of JP-A-2008-195018 are preferred.

As the azide compound (f), a compound, for example, 2,6-bis(4-azidobenzylidene)-4-methylcyclohexanone is exemplified.

As the hexaarylbiimidazole compound (g), for example, compounds described in Paragraph No. [0027] of JP-A-2008-195018 are preferred.

As the organic borate compound (h), for example, compounds described in Paragraph No. [0028] of JP-A-2008-195018 are preferred.

As the disulfone compound (i), for example, compounds described in JP-A-61-166544 and JP-A-2002-328456 are exemplified.

As the oxime ester compound (j), for example, compounds described in Paragraph Nos. [0028] to [0030] of JP-A-2008-195018 are preferred.

As the onium salt compound (k), onium salts, for example, diazonium salts described in S. I. Schlesinger, Photogr. Sci. Eng., 18,387 (1974), T. S. Bal et al., Polymer, 21, 423 (1980) and JP-A-5-158230, ammonium salts described in U.S. Patent 4,069,055 and JP-A-4-365049, phosphonium salts described in U.S. Patents 4,069,055 and 4,069,056, iodonium salts described in European Patent 104,143, U. S. Patent Publication No. 2008/0311520, JP-A-2-150848, JP-A-2008-195018 and J. V. Crivello et al., Macromolecules, 10 (6), 1307 (1977), sulfonium salts described in European Patents 370,693, 233,567, 297,443 and 297,442, U.S. Patents 4,933,377, 4,760,013, 4,734,444 and 2,833,827 and German Patents 2,904,626, 3,604,580 and 3,604,581, selenonium salts described in J. V. Crivello et al., J. Polymer Sci., Polymer Chem. Ed., 17, 1047 (1979), arsonium salts described in C. S. Wen et al., Teh, Proc. Conf. Rad. Curing ASIA, p. 478, Tokyo, Oct. (1988), and azinium salts described in JP-A-2008-195018 are exemplified.

Of the polymerization initiators described above, the onium salt, in particular, the iodonium salt, the sulfonium salt or the azinium salt is more preferred. Specific examples of these compounds are set forth below, but the invention should not be construed as being limited thereto.

Of the iodonium salts, a diphenyliodonium salt is preferred. In particular, a diphenyliodonium salt substituted with an electron donating group, for example, an alkyl group or an alkoxy group is preferred, and an asymmetric diphenyliodonium salt is more preferred. Specific examples of the iodonium salt include diphenyliodonium hexafluorophosphate, 4-methoxyphenyl-4-(2-methylpropyl)phenyliodonium hexafluorophosphate, 4-(2-methylpropyl)phenyl-p-tolyliodonium hexafluorophosphate, 4-hexyloxyphenyl-2,4,6-trimethoxyphenyliodonium hexafluorophosphate, 4-hexyloxyphenyl-2,4-diethoxyphenyliodonium tetrafluoroborate, 4-octyloxyphenyl-2,4,6-trimethoxyphenyliodonium 1-perfluorobutanesulfonate, 4-octyloxyphenyl-2,4,6-trimethoxyphenyliodonium hexafluorophosphate and bis(4-tert-butylphenyl)iodonium tetraphenylborate.

Examples of the sulfonium salt include triphenylsulfonium hexafluorophosphate, triphenylsulfonium benzoylformate, bis(4-chlorophenyl)phenylsulfonium benzoylformate, bis(4-chlorophenyl)4-methylphenylsulfonium tetrafluoroborate, tris(4-chlorophenyl)sulfonium 3,5-bis(methoxycarbonyl)benzenesulfonate and tris(4-chlorophenyl)sulfonium hexafluorophosphate.

Examples of the azinium salt include 1-cyclohexylmethyloxypyridinium hexafluorophosphate, 1-cyclohexyloxy-4-phenylpyridinium hexafluorophosphate, 1-ethoxy-4-phenylpyridinium hexafluorophosphate, 1-(2-ethylhexyloxy)-4-phenylpyridinium hexafluorophosphate, 4-chloro-1-cyclohexylmethyloxypyridinium hexafluorophosphate, 1-ethoxy-4-cyanopyridinium hexafluorophosphate, 3,4-dichloro-1-(2-ethylhexyloxy)pyridinium hexafluorophosphate, 1-benzyloxy-4-phenylpyridinium hexafluorophosphate, 1-phenethyloxy-4-phenylpyridinium hexafluorophosphate, 1-(2-ethylhexyloxy)-4-phenylpyridinium p-toluenesulfonate, 1-(2-ethylhexyloxy)-4-phenylpyridinium perfluorobutanesulfonate, 1-(2-ethylhexyloxy)-4-phenylpyridinium bromide and 1-(2-ethylhexyloxy)4-phenylpyridinium tetrafluoroborate.

The polymerization initiator according to the invention can be added preferably in an amount from 0.1 to 50% by weight, more preferably from 0.5 to 30% by weight, particularly preferably from 0.8 to 20% by weight, based on the total solid content constituting the image-recording layer. In the range described above, good sensitivity and good stain resistance in the non-image area during printing are obtained.

### [Radical polymerizable compound]

The radical polymerizable compound for use in the image-recording layer according to the invention is an addition-polymerizable compound having at least one ethylenically unsaturated double bond and it is selected from compounds having at least one, preferably two or more, terminal ethylenically unsaturated double bonds. The radical polymerizable compound has a chemical form, for example, a monomer, a prepolymer, specifically, a dimer, a trimer or an oligomer, or a mixture thereof.

Examples of the monomer include an unsaturated carboxylic acid (for example, acrylic acid, methacrylic acid, itaconic acid, crotonic acid, isocrotonic acid or maleic acid) and an ester or amide thereof. Preferably, an ester of an unsaturated carboxylic acid with a polyhydric alcohol compound and an amide of an unsaturated carboxylic acid with a polyvalent amine compound are used. An addition reaction product of an unsaturated carboxylic acid ester or amide having a nucleophilic substituent, for example, a hydroxy group, an amino group or a mercapto group, with a monofunctional or polyfunctional isocyanate or epoxy compound, or a dehydration condensation reaction product of an unsaturated carboxylic acid ester or amide with a monofunctional or polyfunctional carboxylic acid is also preferably used. Moreover, an addition reaction product of an unsaturated carboxylic acid ester or amide having an electrophilic substituent, for example, an isocyanate group or an epoxy group with a monofunctional or polyfunctional alcohol, amine or thiol, or a substitution reaction product of an unsaturated carboxylic acid ester or amide having a releasable substituent, for example, a halogen group or a tosyloxy group with a monofunctional or polyfunctional alcohol, amine or thiol is also preferably used. In addition, compounds in which the unsaturated carboxylic acid described above is replaced by an unsaturated phosphonic acid, styrene, vinyl ether or the like can also be used. These compounds are described in references including JP-T-2006-508380, JP-A-2002-287344, JP-A-2008-256850, JP-A-2001-342222, JP-A-9-179296, JP-A-9-179297, JP-A-9-179298, JP-A-2004-294935, JP-A-2006-243493, JP-A-2002-275129, JP-A-2003-64130, JP-A-2003-280187 and JP-A-10-333321.

Specific examples of the monomer, which is an ester of a polyhydric alcohol compound with an unsaturated carboxylic acid, include, as an acrylic acid ester, for example, ethylene glycol diacrylate, 1,3-butanediol diacrylate, tetramethylene glycol diacrylate, propylene glycol diacrylate, trimethylolpropane triacrylate, hexanediol diacrylate, tetraethylene glycol diacrylate, pentaerythritol tetraacrylate, sorbitol triacrylate, isocyanuric acid ethylene oxide (EO) modified triacrylate and polyester acrylate oligomer. As a methacrylic acid ester, for example, tetramethylene glycol dimethacrylate, neopentyl glycol dimethacrylate, trimethylolpropane trimethacrylate, ethylene glycol dimethacrylate, pentaerythritol trimethacrylate, bis[p-(3-methacryloxy- 2-hydroxypropoxy)phenyl]dimethylmethane and bis[p-(methacryloxyethoxy)phenyl]dimethylmethane are exemplified. Specific examples of the monomer, which is an amide of a polyvalent amine compound with an unsaturated carboxylic acid, include methylene bisacrylamide, methylene bismethacrylamide, 1,6-hexamethylene bisacrylamide, 1,6-hexamethylene bismethacrylamide, diethylenetriamine trisacrylamide, xylylene bisacrylamide and xylylene bismethacrylamide.

Urethane type addition-polymerizable compounds produced using an addition reaction between an isocyanate and a hydroxy group are also preferably used and specific examples thereof include vinylurethane compounds having two or more polymerizable vinyl groups per molecule obtained by adding a vinyl monomer containing a hydroxy group represented by formula (b) shown below to a polyisocyanate compound having two or more isocyanate groups per molecule described in JP-B-48-41708.

CH₂=C(R⁴)COOCH₂CH(R⁵)OH (b)

wherein R⁴ and R⁵ each represents H or CH₃.

Also, urethane acrylates as described in JP-A-51-37193, JP-B-2-32293, JP-B-2-16765, JP-A-2003-344997 and JP-A-2006-65210, urethane compounds having an ethylene oxide skeleton described in JP-B-58-49860, JP-B-56-17654, JP-B-62-39417, JP-B-62-39418, JP-A-2000-250211 and JP-A-2007-94138, and urethane compounds having a hydrophilic group described in U.S. Patent 7,153,632, JP-T-8-505958, JP-A-2007-293221 and JP-A-2007-293223 are preferably used.

Of the compounds described above, an isocyanuric acid ethyleneoxide-modified acrylate, for example, tris(acryloyloxyethyl) isocyanurate or bis(acryloyloxyethyl) hydroxyethyl isocyanurate is particularly preferred from the standpoint of excellent balance between hydrophilicity relating to the on-press development property and polymerization ability relating to the printing durability.

Details of the method of using the polymerizable compound, for example, selection of the structure, individual or combination use or the addition amount can be appropriately determined in accordance with the characteristic design of the final lithographic printing plate precursor. The polymerizable compound is used preferably in a range from 5 to 75% by weight, more preferably in a range from 10 to 70% by weight, particularly preferably in a range from 15 to 60% by weight, based on the total solid content of the image-recording layer.

### [Polymer fine particle]

In the invention, a polymer fine particle can be used in order to improve the on-press development property. In particular, a polymer fine particle having a polyalkylene oxide structure is preferred. A polymer fine particle having a polyalkylene oxide group in its side chain is particularly preferred. Due to the polymer fine particle, the permeability of dampening water increases to improve the on-press development property.

The polymer fine particle according to the invention is preferably a hydrophobizing precursor capable of converting the image-recording layer to be hydrophobic when heat is applied. The polymer fine particle of hydrophobizing precursor is preferably at least one fine particle selected from hydrophobic thermoplastic polymer fine particle, thermo-reactive polymer fine particle, microcapsule having a hydrophobic compound encapsulated therein and microgel (crosslinked polymer fine particle). Among them, polymer fine particle having a polymerizable group and microgel are preferred. In order to improve the on-press development property, it is preferred to have a polyalkylene oxide structure as described above.

As the hydrophobic thermoplastic polymer fine particle, hydrophobic thermoplastic polymer fine particles described, for example, in Research Disclosure, No. 333003, January (1992), JP-A-9-123387, JP-A-9-131850, JP-A-9-171249, JP-A-9-171250 and European Patent 931,647 are preferably exemplified.

Specific examples of the polymer constituting the polymer fine particle include a homopolymer or copolymer of a monomer, for example, ethylene, styrene, vinyl chloride, methyl acrylate, ethyl acrylate, methyl methacrylate, ethyl methacrylate, vinylidene chloride, acrylonitrile, vinyl carbazole or an acrylate or methacrylate having a polyalkylene structure and a mixture thereof. Among them, polystyrene, a copolymer containing styrene and acrylonitrile and polymethyl methacrylate are more preferred.

The average particle size of the hydrophobic thermoplastic polymer fine particle for use in the invention is preferably from 0.01 to 2.0 µm.

The thermo-reactive polymer fine particle for use in the invention includes polymer fine particle having a thermo-reactive group and forms a hydrophobized region by crosslinkage due to thermal reaction and change in the functional group involved therein.

As the thermo-reactive group of the polymer fine particle having a thermo-reactive group for use in the invention, although a functional group performing any reaction can be used as long as a chemical bond is formed. For instance, an ethylenically unsaturated group (for example, an acryloyl group, a methacryloyl group, a vinyl group or an allyl group) performing a radical polymerization reaction, a cationic polymerizable group (for example, a vinyl group or a vinyloxy group), an isocyanate group performing an addition reaction or a blocked form thereof, an epoxy group, a vinyloxy group and a functional group having an active hydrogen atom (for example, an amino group, a hydroxy group or a carboxyl group) as the reaction partner thereof, a carboxyl group performing a condensation reaction and a hydroxyl group or an amino group as the reaction partner thereof, and an acid anhydride performing a ring opening addition reaction and an amino group or a hydroxyl group as the reaction partner thereof are preferably exemplified.

As the microcapsule for use in the invention, microcapsule having all or part of the constituting components of the image-recording layer encapsulated as described, for example, in JP-A-2001-277740 and JP-A-2001-277742 is exemplified. The constituting components of the image-recording layer may be present outside the microcapsules. It is a more preferred embodiment of the image-recording layer containing microcapsules that the hydrophobic constituting components are encapsulated in microcapsules and the hydrophilic components are present outside the microcapsules.

According to the invention, an embodiment containing a crosslinked resin particle, that is, a microgel may be used. The microgel can contain a part of the constituting components of the image-recording layer in at least one of its inside and its surface. In particular, an embodiment of a reactive microgel containing the radical polymerizable compound (c) on the surface thereof is preferred in view of the image-forming sensitivity and printing durability.

In order to conduct microencapsulation or microgelation of the constituting component of the image-recording layer, known methods can be used.

The average particle size of the microcapsule or microgel is preferably from 0.01 to 3.0 µm, more preferably from 0.05 to 2.0 µm, particularly preferably from 0.10 to 1.0 µm. In the range described above, good resolution and good time lapse stability can be achieved.

The content of the polymer fine particle is preferably in a range from 5 to 90% by weight based on the total solid content of the image-recording layer.

### [Other components of image-recording layer)

Into the image-recording layer according to the invention, various additives can be further incorporated, if desired. Examples of the additive used include a surfactant for progressing the development property and improving the surface state of coated layer, a coated surface state improving agent, a microcapsule for providing good compatibility between the development property and the printing durability of a lithographic printing plate prepared from the lithographic printing plate precursor, a hydrophilic polymer for improving the development property and dispersion stability of microcapsule, a coloring agent or print-out agent for visually distinguishing the image area from the non-image area, a polymerization inhibitor for preventing undesirable thermal polymerization of the radical polymerizable compound during the production or preservation of the image-recording layer, a hydrophobic low molecular weight compound, for example, a higher fatty acid derivative for avoiding polymerization inhibition due to oxygen, a fine inorganic particle for increasing strength of the cured layer in the image area, a fine organic particle, a hydrophilic low molecular weight compound for improving the development property, a co-sensitizer or chain transfer agent for increasing sensitivity, a plasticizer for improving plasticity, and an oil-sensitizing agent, for example, a phosphonium compound, a nitrogen-containing low molecular weight compound or an ammonium group-containing polymer, for improving ink receptivity. As the additives, known compounds can be used and, for example, compounds described in Paragraph Nos. [0161] to [0215] of JP-A-2007-206217, Paragraph No. [0067] of JP-T-2005-509192, Paragraph Nos. [0023] to [0026] and [0059] to [0066] of JP-A-2004-310000, Paragraph Nos. [0222] to [0231] of JP-A-2009-29124, Paragraph Nos. [0039] to [0042] of JP-A-2007-50660, Paragraph Nos. [0021] to [0037] of JP-A-2008-284858, Paragraph Nos. [0030] to [0057] of JP-A-2009-90645 and Paragraph Nos. [0089] to [0105] of JP-A-2009-208458 are used.

### [Formation of image-recording layer]

The image-recording layer according to the invention is formed by dispersing or dissolving each of the necessary components described above in a solvent to prepare a coating solution and coating the solution. The solvent used include, for example, methyl ethyl ketone, ethylene glycol monomethyl ether, 1-methoxy-2-propanol, 2-methoxyethyl acetate, 1-methoxy-2-propyl acetate and γ-butyrolactone, but the invention should not be construed as being limited thereto. The solvents may be used individually or as a mixture. The solid content concentration of the coating solution is preferably from 1 to 50% by weight.

The coating amount (solid content) of the image-recording layer on the support after the coating and drying is preferably from 0.3 to 3.0 g/m². Various methods can be used for the coating. Examples of the method include bar coater coating, spin coating, spray coating, curtain coating, dip coating, air knife coating, blade coating and roll coating.

### (Support)

The support for use in the lithographic printing plate precursor according to the invention is not particularly restricted so far as it is a dimensionally stable plate-like hydrophilic support. Particularly, an aluminum plate is preferred. In advance of the use of an aluminum plate, the aluminum plate is preferably subjected to a surface treatment, for example, roughening treatment or anodizing treatment. The roughening treatment of the surface of the aluminum plate is conducted by various methods and includes, for example, mechanical roughening treatment, electrochemical roughening treatment (roughening treatment of electrochemically dissolving the surface) and chemical roughening treatment (roughening treatment of chemically dissolving the surface selectively). With respect to the treatments, methods described in Paragraph Nos. [0241] to [0245] of JP-2007-206217 can be preferably used.

Also, an enlarging treatment or a sealing treatment of micropores of the anodized layer described in JP-A-2001-253181 and JP-A-2001-322365 or a surface hydrophilizing treatment, for example, with an alkali metal silicate as described in U.S. Patents 2,714,066, 3,181,461, 3,280,734 and 3,902,734 or polyvinyl phosphonic acid as described in U.S. Patents 3,276,868, 4,153,461 and 4,689,272 may be appropriately selected and applied to the aluminum plate, if desired.

The support preferably has center line average roughness from 0.10 to 1.2 µm. In the range described above, good adhesion property to the image-recording layer and good printing durability and good resistance to stain of a lithographic printing plate prepared from the lithographic printing plate precursor are achieved.

Also, the color density of the support is preferably from 0.15 to 0.65 in terms of the reflection density value. In the range described above, good image-forming property by prevention of halation at the image exposure and good aptitude for plate inspection after development are achieved.

The thickness of the support is preferably from 0.1 to 0.6 mm, more preferably from 0.15 to 0.4 mm, and still more preferably from 0.2 to 0.3 mm.

The support according to the invention may have a backcoat layer containing an organic polymer compound described in JP-A-5-45885 or an alkoxy compound of silicon described in JP-A-6-35174, provided on the back surface thereof, if desired.

### (Undercoat layer)

In the lithographic printing plate precursor according to the invention, it is preferred to provide an undercoat layer between the image-recording layer and the support. Since the undercoat layer makes removal of the image-recording layer from the support in the unexposed area easy, it is suitable for the printing method according to the invention and the on-press development property is particularly improved. Further, it is advantageous that in the case of infrared laser exposure, since the undercoat layer acts as a heat insulating layer, heat generated upon the exposure does not diffuse into the support and is efficiently utilized and as a result, the increase in sensitivity can be achieved.

The undercoat layer preferably contains a polymer compound having a hydrophilic group and a group adsorbing on a surface of the support. The polymer compound is preferably a polymer resin obtained by copolymerization of a monomer having an adsorbing group/a monomer having a hydrophilic group and more preferably a polymer resin obtained by copolymerization of a monomer having an adsorbing group/a monomer having a hydrophilic group/a monomer having a crosslinkable group.

Whether adsorptivity to the hydrophilic surface of support is present or not can be judged, for example, by the method shown below.

A test compound is dissolved in an easily soluble solvent to prepare a coating solution, and the coating solution is coated and dried on a support so as to have the coating amount after drying of 30 mg/m². After thoroughly washing the support coated with the test compound using the easily soluble solvent, the residual amount of the test compound that has not been removed by the washing is measured to calculate the adsorption amount of the test compound to the support. For measuring the residual amount, the residual amount of the test compound may be directly determined, or may be calculated by determining the amount of the test compound dissolved in the washing solution. The determination for the test compound can be performed, for example, by X-ray fluorescence spectrometry measurement, reflection absorption spectrometry measurement or liquid chromatography measurement. The compound having the adsorptivity to support is a compound that remains by 1 mg/m² or more even after conducting the washing treatment described above.

The adsorbing group to the hydrophilic surface of support is a functional group capable of forming a chemical bond (for example, an ionic bond, a hydrogen bond, a coordinate bond or a bond with intermolecular force) with a substance (for example, metal or metal oxide) or a functional group (for example, a hydroxy group) present on the hydrophilic surface of support. The adsorbing group is preferably an acid group or a cationic group.

The acid group preferably has an acid dissociation constant (pKa) of 7 or less. Examples of the acid group include a phenolic hydroxy group, a carboxyl group, -PO₃H₂, -OPO₃H₂ and -COCH₂COCH₃. Among them, -OPO₃H₂ and -PO₃H₂ are particularly preferred. The acid group may be the form of a metal salt.

The cationic group is preferably an onium group. Examples of the onium group include an ammonium group, a phosphonium group, an arsonium group, a stibonium group, an oxonium group, a sulfonium group, a selenonium group, a stannonium group and iodonium group. An ammonium group, a phosphonium group and a sulfonium group are preferred, an ammonium group and a phosphonium group are more preferred, and an ammonium group is most preferred.

Particularly preferable examples of the monomer having the adsorbing group include a compound represented by formula (III) or (IV) shown below.

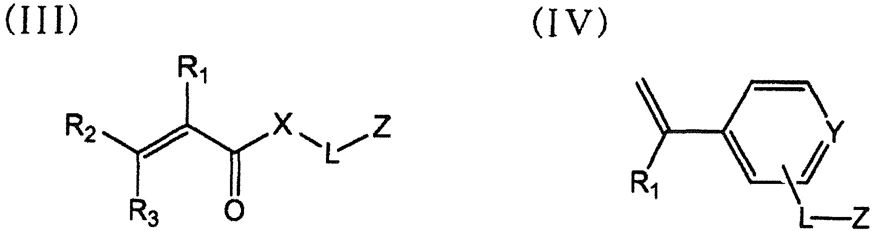

In formula (III), R₁, R₂ and R₃ each independently represents a hydrogen atom, halogen atom or an alkyl group having from 1 to 6 carbon atoms. R₁, R₂ and R₃ each independently represents preferably a hydrogen atom or an alkyl group having from 1 to 6 carbon atoms, more preferably a hydrogen atom or an alkyl group having from 1 to 3 carbon atoms, most preferably a hydrogen atom or a methyl group. It is particularly preferred that R² and R³ each represents a hydrogen atom.

In formula (III), X represents an oxygen atom (-O-) or imino group (-NH-). X is preferably an oxygen atom. In formula (III), L represents a divalent connecting group. It is preferred that L represents a divalent aliphatic group (for example, an alkylene group, a substituted alkylene group, an alkenylene group, a substituted alkenylene group, an alkinylene group or a substituted alkinylene group), a divalent aromatic group (for example, an arylene group or a substituted arylene group), a divalent heterocyclic group or a combination of each of these groups with an oxygen atom (-O-), a sulfur atom (-S-), an imino group (-NH-), a substituted imino group (-NR-, wherein R represents an aliphatic group, an aromatic group or a heterocyclic group) or a carbonyl group (-CO-).

The aliphatic group may have a cyclic structure or a branched structure. A number of carbon atoms of the aliphatic group is preferably from 1 to 20, more preferably from 1 to 15, most preferably from 1 to 10. It is preferred that the aliphatic group is a saturated aliphatic group rather than an unsaturated aliphatic group. The aliphatic group may have a substituent. Examples of the substituent include a halogen atom, a hydroxy group, an aromatic group and a heterocyclic group.

A number of carbon atoms of the aromatic group is preferably from 6 to 20, more preferably from 6 to 15, most preferably from 6 to 10. The aromatic group may have a substituent. Examples of the substituent include a halogen atom, a hydroxy group, an aliphatic group, an aromatic group and a heterocyclic group.

It is preferred that the heterocyclic group has a 5-membered or 6-membered ring as the hetero ring. Other heterocyclic ring, an aliphatic ring or an aromatic ring may be condensed to the heterocyclic ring. The heterocyclic group may have a substituent. Examples of the substituent include a halogen atom, a hydroxy group, an oxo group (=O), a thioxo group (=S), an imino group (=NH), a substituted imino group (=N-R, wherein R represents an aliphatic group, an aromatic group or a heterocyclic group), an aliphatic group, an aromatic group and a heterocyclic group.

It is preferred that L represents a divalent connecting group containing a plurality of polyoxyalkylene structures. It is more preferred that the polyoxyalkylene structure is a polyoxyethylene structure. In other words, it is preferred that L contains -(OCH₂CH₂)ₙ- (n is an integer of 2 or more).

In formula (III), Z represents a functional group adsorbing to the hydrophilic surface of support.

In formula (IV), R₁, L and Z have the same meanings as defined in formula (III), respectively.

Y represents a carbon atom or a nitrogen atom. In the case where Y is a nitrogen atom and L is connected to Y to form a quaternary pyridinium group, Z is not mandatory and may represents a hydrogen atom because the quaternary pyridinium group itself exhibits the adsorptivity.

Examples of the representative monomer represented by formula (III) or (IV) are set forth below.

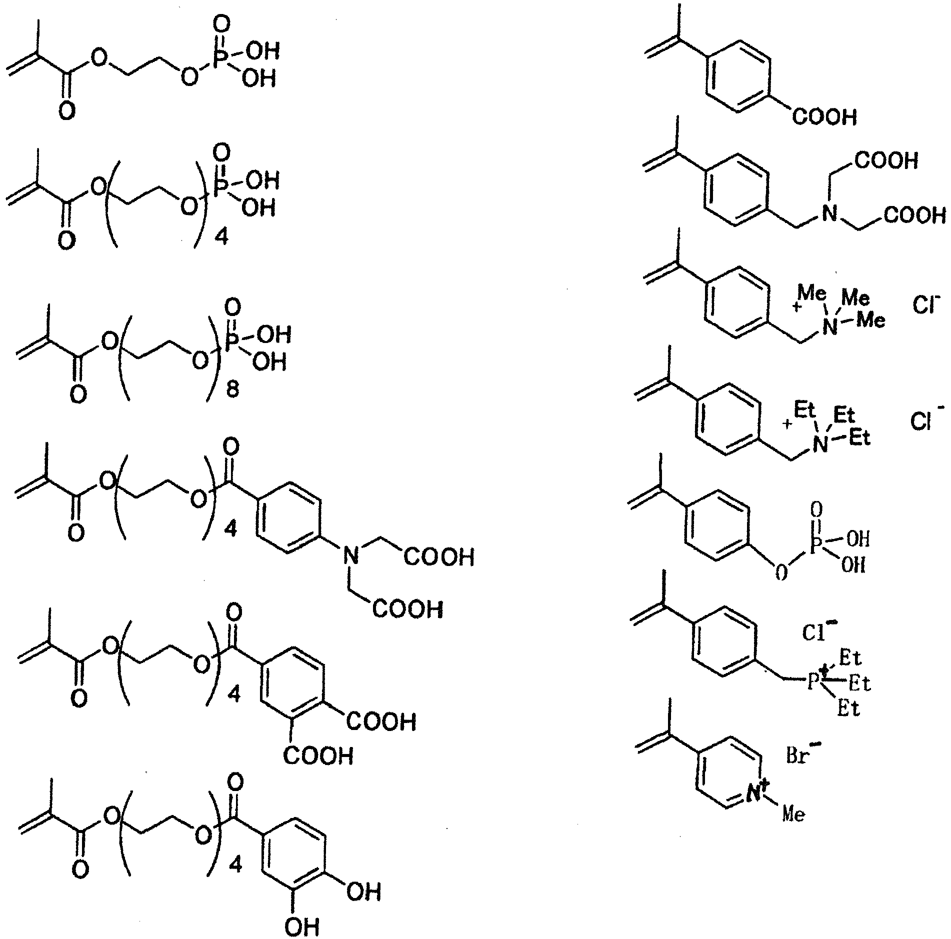

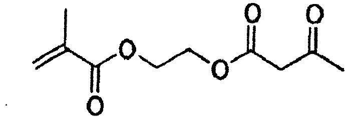

The hydrophilic group in the polymer resin for the undercoat layer which can be used in the invention preferably includes, for example, a carboxylate group, a polyoxyethyl group, a polyoxypropyl group and a sulfonic acid group. Among them, a monomer having a sulfonic acid group or a polyoxyethyl group, each exhibiting a highly hydrophilic property is preferred.

Specific examples of the monomer having a sulfonic acid group include a sodium salt or amine salt of methallyloxybenzenesulfonic acid, allyloxybenzenesulfonic acid, allylsulfonic acid, vinylsulfonic acid, allylsulfonic acid, p-styrenesulfonic acid, methallylsulfonic acid, acrylamido-tert-butylsulfonic acid, 2-acrylamido-2-methylpropanesulfonic acid and (3-acryloyloxypropyl)buthylsulfonic acid. Among them, from the standpoint of the hydrophilic performance and handling property in the synthesis thereof, sodium salt of 2-acrylamido-2-methylpropanesulfonic acid is preferred.

The water-soluble polymer resin for undercoat layer according to the invention preferably has a crosslinkable group. The crosslinkable group acts to improve the adhesion to the image area. In order to impart the crosslinking property to the polymer resin for undercoat layer, introduction of a crosslinkable functional group, for example, an ethylenically unsaturated bond into the side chain of the polymer or introduction by formation of a salt structure between a polar substituent of the polymer resin and a compound containing a substituent having a counter charge to the polar substituent of the polymer resin and an ethylenically unsaturated bond is used.

Examples of the polymer having the ethylenically unsaturated bond in the side chain thereof include a polymer of an ester or amide of acrylic acid or methacrylic acid, wherein the ester or amide residue (R in -COOR or -CONHR) has the ethylenically unsaturated bond.

Examples of the residue (R described above) having an ethylenically unsaturated bond include -(CH₂)ₙCR¹=CR²R³, -(CH₂O)ₙCH₂CR¹=CR²R³, -(CH₂CH₂O)ₙCH₂CR¹=CR²R³, -(CH₂)ₙNH-CO-O-CH₂CR¹=CR²R³, -(CH₂)ₙ-O-CO-CR¹=CR²R³ and -(CH₂CH₂O)₂-X (wherein R¹ to R³ each represents a hydrogen atom, a halogen atom or an alkyl group having from 1 to 20 carbon atoms, an aryl group, alkoxy group or aryloxy group, or R¹ and R² or R¹ and R³ may be combined with each other to form a ring. n represents an integer of 1 to 10. X represents a dicyclopentadienyl residue).

Specific examples of the ester residue include -CH₂CH=CH₂ (described in JP-B-7-21633) -CH₂CH₂O-CH₂CH=CH₂, -CH₂C(CH₃)=CH₂, -CH₂CH=CH-C₆H₅, -CH₂CH₂OCOCH=CH-C₆H₅, -CH₂CH₂-NHCOO-CH₂CH=CH₂ and -CH₂CH₂O-X (wherein X represents a dicyclopentadienyl residue).

Specific examples of the amide residue include -CH₂CH=CH₂, -CH₂CH₂-Y (wherein Y represents a cyclohexene residue) and -CH₂CH₂OCO-CH=CH₂.

As a monomer having a crosslinkable group for the polymer resin for undercoat layer, an ester or amide of acrylic acid or methacrylic acid having the crosslinkable group described above is preferably used.

The content of the crosslinkable group (content of the radical polymerizable unsaturated double bond determined by iodine titration) in the polymer resin for undercoat layer is preferably from 0.1 to 10.0 mmol, more preferably from 1.0 to 7.0 mmol, most preferably from 2.0 to 5.5 mmol, based on 1 g of the polymer resin. In the range described above, compatibility between good sensitivity and good stain resistance and good preservation stability can be achieved.

The weight average molecular weight (Mw) of the polymer resin for undercoat layer is preferably 5,000 or more, more preferably from 10,000 to 300,000. The number average molecular weight (Mn) of the polymer resin is preferably 1,000 or more, more preferably from 2,000 to 250,000. The polydispersity (Mw/Mn) thereof is preferably from 1.1 to 10.

The polymer resin for undercoat layer may be any of a random polymer, a block polymer, a graft polymer and the like, and is preferably a random polymer.

The polymer resins for undercoat layer may be used individually or in a mixture of two or more thereof.

The polymer resin for undercoat layer is dissolved in a solvent and used as a coating solution for undercoat layer. As the solvent, any solvent may be used as long as it is able to dissolve or disperse the polymer resin for undercoat layer and it volatilizes at a drying step after coating. For example, a solvent used in the formation of the image-recording layer can be employed.

The undercoat layer according to the invention may contain a chelating agent, a secondary or tertiary amine, a polymerization inhibitor or a compound containing an amino group or a functional group having polymerization inhibition ability and a group capable of interacting with a surface of aluminum support (for example, 1,4-diazabicyclo[2,2,2]octane (DABCO), 2,3,5,6-tetrahydroxy-p-quinone, chloranil, sulfophthalic acid, hydroxyethylethylenediaminetriacetic acid, dihydroxyethylethylenediaminediacetic acid or hydroxyethyliminodiacetic acid) in addition to the compound for undercoat layer described above in order to prevent the occurrence of stain due to the lapse of time.

The undercoat layer is coated according to a known method. The coating amount (solid content) of the undercoat layer is preferably from 0.1 to 100 mg/m², and more preferably from 1 to 30 mg/m².

### (Protective layer)

In the lithographic printing plate precursor according to the invention, it is preferred to provide a protective layer (overcoat layer) on the image-recording layer. The protective layer has a function for preventing, for example, occurrence of scratch in the image-recording layer or ablation caused by exposure with a high illuminance laser beam, in addition to the function for restraining an inhibition reaction against the image formation by means of oxygen blocking.

With respect to the protective layer having such properties, there are described, for example, in U.S. Patent 3,458,311 and JP-B-55-49729. As a polymer having low oxygen permeability for use in the protective layer, any water-soluble polymer and water-insoluble polymer can be appropriately selected to use. The polymers may be used in mixture of two or more thereof, if desired. Specifically, for example, polyvinyl alcohol, a modified polyvinyl alcohol, polyvinyl pyrrolidone, a water-soluble cellulose derivative and poly(meth)acrylonitrile are exemplified.

As the modified polyvinyl alcohol, an acid-modified polyvinyl alcohol having a carboxyl group or a sulfo group is preferably used. Specifically, modified polyvinyl alcohols described in JP-A-2005-250216 and JP-A-2006-259137 are preferably exemplified.

It is also preferred for the protective layer to contain an inorganic stratiform compound, for example, natural mica or synthetic mica as described in JP-A-2005-119273 in order to increase the oxygen blocking property.

Further, the protective layer may contain a known additive, for example, a plasticizer for imparting flexibility, a surfactant for improving a coating property or a fine inorganic particle for controlling a surface slipping property. The oil-sensitizing agent described with respect to the image-recording layer may also be incorporated into the protective layer.

The protective layer is coated according to a known method. The coating amount of the protective layer is preferably in a range from 0.01 to 10 g/m², more preferably in a range from 0.02 to 3 g/m², most preferably in a range from 0.02 to 1 g/m², in terms of the coating amount after drying.

The adhesion property to the image area and scratch resistance of the protective layer are also extremely important in view of handling of the lithographic printing plate precursor. Specifically, when a hydrophilic layer comprising a water-soluble polymer is stacked on the oleophilic polymerizable layer, layer peeling due to an insufficient adhesion property is liable to occur, and the peeled portion causes such a defect as failure in curing of the photosensitive layer due to polymerization inhibition by oxygen. Various proposals have been made for improving the adhesion property between two layers. For example, it is described in JP-B-54-12215 and BP-A-1303578 that a sufficient adhesion property can be obtained by mixing from 20 to 60% by weight of an acryl-based emulsion or a water-insoluble vinyl pyrrolidone/vinyl acetate copolymer with a hydrophilic polymer mainly composed of polyvinyl alcohol and stacking the resulting mixture on the polymerizable layer. Any of these known techniques can be applied to the protective layer according to the invention. Coating methods of the protective layer are described in detail, for example, in U.S. Patent 3,458,311 and JP-B-55-49729.

### EXAMPLES

The invention will be described in detail with reference to the examples, but the invention should not be construed as being limited thereto. A ratio of repeating units described with respect to the polymer used in the example is expressed as a molar ratio.

### [Preparation of Lithographic printing plate precursors (1) to (3)]

### 1. Preparation of Lithographic printing plate precursor (1)

### (1) Preparation of Support

An aluminum plate (material: JIS A 1050) having a thickness of 0.3 mm was subjected to a degreasing treatment at 50°C for 30 seconds using a 10% by weight aqueous sodium aluminate solution in order to remove rolling oil on the surface thereof and then grained the surface thereof using three nylon brushes embedded with bundles of nylon bristle having a diameter of 0.3 mm and an aqueous suspension (specific gravity: 1.1 g/cm³) of pumice having a median size of 25 µm, followed by thorough washing with water. The plate was subjected to etching by immersing in a 25% by weight aqueous sodium hydroxide solution of 45°C for 9 seconds, washed with water, then immersed in a 20% by weight nitric acid at 60°C for 20 seconds, and washed with water. The etching amount of the grained surface was about 3 g/m².

Then, using an alternating current of 60 Hz, an electrochemical roughening treatment was continuously carried out on the plate. The electrolytic solution used was a 1% by weight aqueous nitric acid solution (containing 0.5% by weight of aluminum ion) and the temperature of electrolytic solution was 50°C. The electrochemical roughening treatment was conducted using a rectangular alternating current having a trapezoidal waveform such that the time TP necessary for the current value to reach the peak from zero was 0.8 msec and the duty ratio was 1:1, and using a carbon electrode as a counter electrode. A ferrite was used as an auxiliary anode. The current density was 30 A/dm² in terms of the peak value of the electric current, and 5% of the electric current flowing from the electric source was divided to the auxiliary anode. The quantity of electricity in the nitric acid electrolysis was 175 C/dm² in terms of the quantity of electricity when the aluminum plate functioned as an anode. The plate was then washed with water by spraying.

Then, the plate was further subjected to an electrochemical roughening treatment in the same manner as in the nitric acid electrolysis above using as an electrolytic solution, a 0.5% by weight aqueous hydrochloric acid solution (containing 0.5% by weight of aluminum ion) having temperature of 50°C and under the condition that the quantity of electricity was 50 C/dm² in terms of the quantity of electricity when the aluminum plate functioned as an anode. The plate was then washed with water by spraying.

The plate was then subjected to an anodizing treatment using as an electrolytic solution, 15% by weight sulfuric acid (containing 0.5% by weight of aluminum ion) at a current density of 15 A/dm² to form a direct current anodized film of 2.5 g/m², washed with water and dried to prepare Support (1).

Thereafter, in order to ensure the hydrophilicity of the non-image area, Support (1) was subjected to silicate treatment using a 2.5% by weight aqueous sodium silicate No. 3 solution at 60°C for 10 seconds and then was washed with water to obtain Support (2). The adhesion amount of Si was 10 mg/m². The center line average roughness (Ra) of the support was measured using a stylus having a diameter of 2 µm and found to be 0.51 µm.

### (2) Formation of Undercoat layer

Coating solution (1) for undercoat layer shown below was coated on Support (2) described above so as to have a dry coating amount of 20 mg/m² to prepare a support having an undercoat layer for use in the experiments described below.

### <Coating solution (1) for undercoat layer>

| | |
|---|---|
| Compound (1) for undercoat layer having structure shown below | 0.18 g |
| Hydroxyethyliminodiacetic acid | 0.10 g |
| Methanol | 55.24 g |
| Water | 6.15 g |

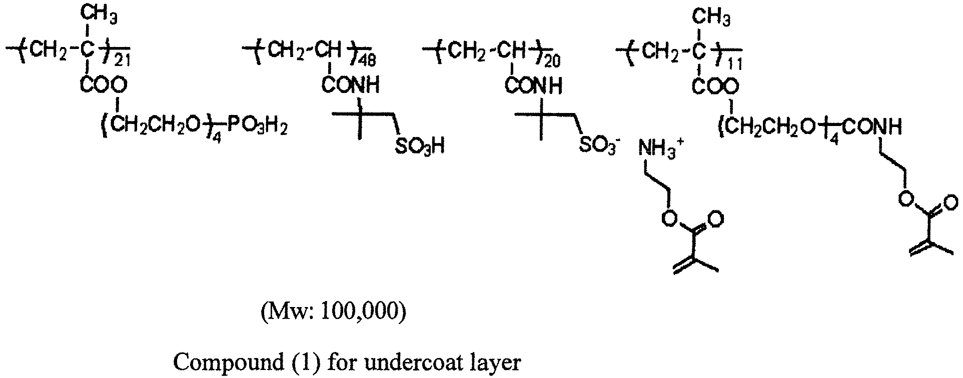

### (3) Formation of Image-recording layer

Coating solution (1) for image-recording layer having the composition shown below was coated on the undercoat layer formed as described above by a bar and dried in an oven at 100°C for 60 seconds to form an image-recording layer having a dry coating amount of 1.0 g/m².

Coating solution (1) for image-recording layer was prepared by mixing Photosensitive solution (1) shown below with Microgel solution (1) shown below just before the coating, followed by stirring.

### <Photosensitive solution (1)>

| | |
|---|---|
| Binder polymer (1) having structure shown below | 0.240 g |
| Infrared absorbing dye (1) having structure shown below | 0.030 g |
| Polymerization initiator (1) having structure shown below | 0.162 g |
| Radical polymerizable compound (Tris(acryloyloxyethyl) isocyanurate (NK ESTER A-9300, produced by Shin-Nakamura Chemical Co., Ltd.)) | 0.192 g |
| Hydrophilic low molecular weight compound (Tris(2-hydroxyethyl) isocyanurate) | 0.062 g |
| Hydrophilic low molecular weight compound (1) having structure shown below | 0.050 g |
| Oil-sensitizing agent (Phosphonium compound (1) having structure shown below) | 0.055 g |
| Oil-sensitizing agent (Benzyl dimethyl octyl ammonium PF₆ salt) | 0.018 g |
| Oil-sensitizing agent (Ammonium group-containing polymer having structure shown below (reduced specific viscosity: 44 cSt/g/ml) | 0.035 g |
| Fluorine-based surfactant (1) having structure shown below | 0.008 g |
| 2-Butanone | 1.091 g |
| 1-Methoxy-2-propanol | 8.609 g |

### <Microgel solution (1)>

| | |
|---|---|
| Microgel (1) | 2.640 g |
| Distilled water | 2.425 g |

The structures of Binder polymer (1), Infrared absorbing dye (1), Polymerization initiator (1), Phosphonium compound (1), Hydrophilic low molecular weight compound (1), Ammonium group-containing polymer and Fluorine-based surfactant (1) are shown below.

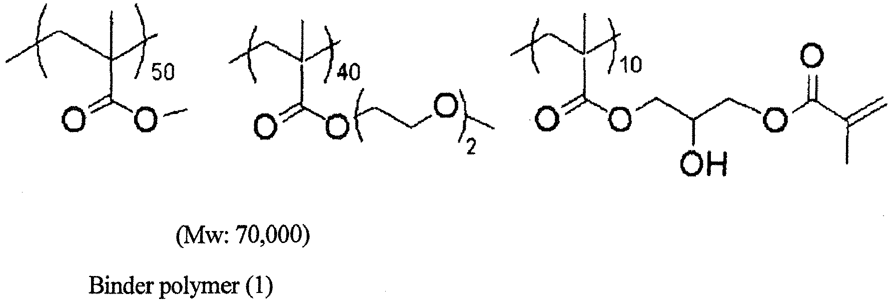

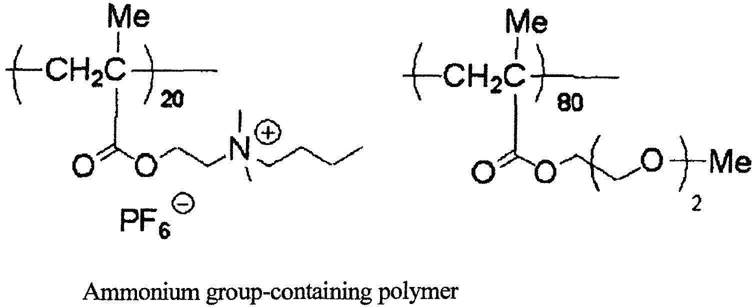

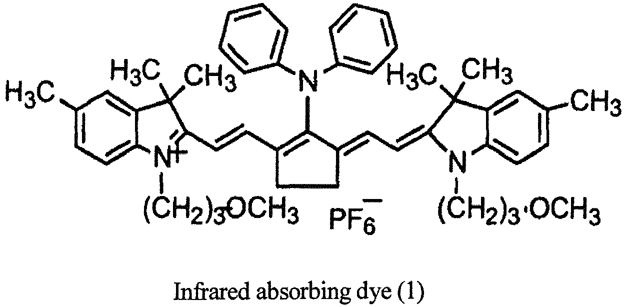

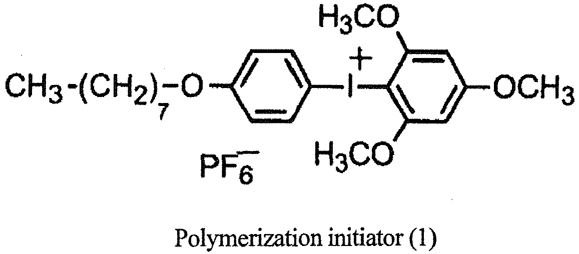

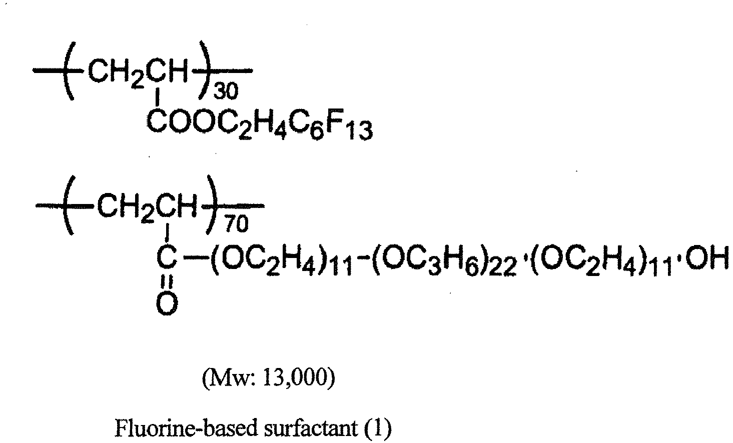

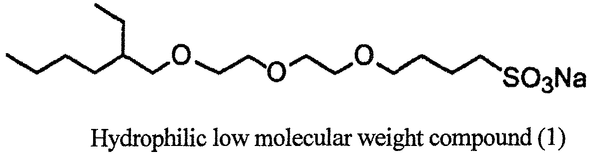

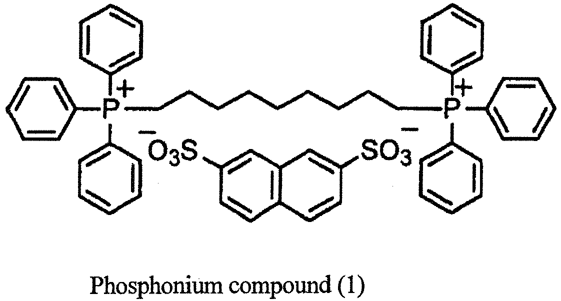

### <Preparation of Microgel (1)>

An oil phase component was prepared by dissolving 10 g of an adduct of trimethylolpropane and xylene diisocyanate (TAKENATE D-110N, produced by Mitsui Chemicals, Inc.), 3.15 g of pentaerythritol triacrylate (SR444, produced by Nippon Kayaku Co., Ltd.) and 0.1 g of PIONIN A-41C (produced by Takemoto Oil & Fat Co., Ltd.) in 17 g of ethyl acetate. As an aqueous phase component, 40 g of a 4% by weight aqueous solution of Kuraray POVAL PVA-205 (polyvinyl alcohol, saponification degree: 86.5 to 89.0% by mole, produced by Kuraray Co., Ltd.) was prepared. The oil phase component and the aqueous phase component were mixed and emulsified using a homogenizer at 12,000 rpm for 10 minutes. The resulting emulsion was added to 25 g of distilled water and stirred at room temperature for 30 minutes and then at 50°C for 3 hours. The microgel liquid thus-obtained was diluted using distilled water so as to have the solid content concentration of 15% by weight to prepare Microgel (1). The average particle size of the microgel was measured by a light scattering method and found to be 0.2 µm.

### (4) Formation of Protective layer

Coating solution (1) for protective layer having the composition shown below was coated on the image-recording layer described above by a bar and dried in an oven at 120°C for 60 seconds to form a protective layer having a dry coating amount of 0.15 g/m², thereby preparing Lithographic printing plate precursor (1).

### <Coating solution (1) for protective layer>

| | |
|---|---|
| Dispersion of inorganic stratiform compound (1) | 1.5 g |
| Aqueous 6% by weight solution of polyvinyl alcohol (CKS 50, sulfonic acid-modified, saponification degree: 99% by mole or more, polymerization degree: 300, produced by Nippon Synthetic Chemical Industry Co., Ltd.) | 0.55 g |
| Aqueous 6% by weight solution of polyvinyl alcohol (PVA-405, saponification degree: 81.5% by mole, polymerization degree: 500, produced by Kuraray Co., Ltd.) | 0.03 g |
| Aqueous 1% by weight solution of surfactant (EMALEX 710, produced by Nihon Emulsion Co., Ltd.) | 0.86 g |
| Ion-exchanged water | 6.0 g |

### <Preparation of Dispersion of inorganic stratiform compound (1)>

To 193.6 g of ion-exchanged water was added 6.4 g of synthetic mica (SOMASIF ME-100, produced by CO-OP Chemical Co., Ltd.) and the mixture was dispersed using a homogenizer until an average particle size (according to a laser scattering method) became 3 µm to prepare Dispersion of inorganic stratiform compound (1). The aspect ratio of the inorganic particle thus-dispersed was 100 or more.

### 2. Preparation of Lithographic printing plate precursor (2)

Lithographic printing plate precursor (2) was prepared in the same manner as in Lithographic printing plate precursor (1) except that the undercoat layer was not provided.

### 3. Preparation of Lithographic printing plate precursor (3)

Lithographic printing plate precursor (3) was prepared in the same manner as in Lithographic printing plate precursor (1) except for changing Binder polymer (1) in the image-recording layer of Lithographic printing plate precursor (1) to Binder polymer (2) shown below.

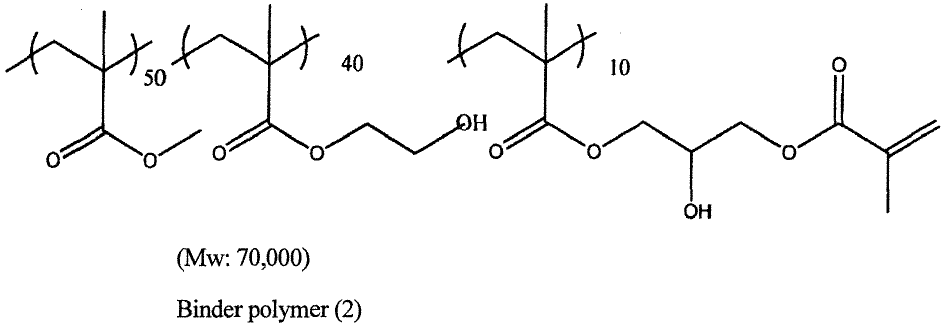

### Example 1

Using Lithographic printing plate precursor (1) obtained as above, printing was performed in the order of steps (i) → (ii) → (iii) → (iv) → (v) shown below.

### (i) Exposing imagewise the lithographic printing plate precursor and then mounting on a plate cylinder of a printing machine

The lithographic printing plate precursor thus-obtained was exposed by LUXEL PLATESETTER T-6000III equipped with an infrared semiconductor laser produced by FUJIFILM Corp. under the conditions of a rotation number of an external drum of 1,000 rpm, laser output of 70% and resolution of 2,400 dpi. The exposed image contained a solid image, a solid non-image and a 50% halftone dot chart of a 20 µm-dot FM screen.

The exposed lithographic printing plate precursor was mounted without undergoing development processing on a plate cylinder of a printing machine (Spica 26, produced by Komori Corp.) equipped with a Komorimatic water supply device shown in Fid. 4.

In the printing machine, ECOLITY-2 (produced by FUJIFILM Corp.)/water = 2/98 (volume ratio) was put into a water pan (at temperature of 20°C) as dampening water supplied during printing, and the supply amount of dampening water was set at 10 ml/m².

SPACE COLOR FUSION G black ink (produced by DIC Graphics Corp.) was used as printing ink.

### (ii) Injecting by spraying of dampening water

The dampening water (ECOLITY-2 (produced by FUJIFILM Corp.)/water = 2/98 (volume ratio) at temperature of 25°C) was uniformly injected to a roller for supplying water to dampening roller (roller (22) in Fig. 4) by a household spray bottle (sprayer) at a ratio of 50 ml/m² per unit area of the lithographic printing plate precursor mounted on the plate cylinder.

### (iii) Rotating water feed rollers

After the supply by spraying, water feed rollers were rotated. The rotation was conducted 9 times in terms of rotation number of a dampening roller.

### (iv) Bringing the dampening roller into contact with the lithographic printing plate precursor

The dampening roller was brought into contact with the lithographic printing plate precursor, and then the plate cylinder was rotated 10 times.

### (v) Supplying printing ink from an inking roller to the lithographic printing plate precursor, and supplying printing paper to the plate cylinder

Printing paper (TOKUBISHI art paper (76.5 kg)) was supplied at the same time as the ink supply.

The printing was performed at a printing speed of 6,000 sheets per hour.

### [Evaluation of on-press development property]

A number of waste sheets until the non-image area was clearly subjected to on-press development and printed material without stain was obtained was evaluated. The result obtained is shown in Table 1.

### [Evaluation of printing unevenness]

On the printed material which corresponded to the printed material without stain was obtained unevenness of the 50% halftone dot image of 20 µm-dot FM screen was evaluated according to the criteria shown below. The result obtained is shown in Table 1.
A: Ink is uniformly attached.
B: Ink is attached, but slight something like unevenness is observed. It is at an acceptable level as printed material.
C: Ink is attached, but unevenness is observed.
D: Ink is difficult to be attached (low density).

### Examples 2 to 8

The printing and evaluation were performed in the same manner as in Example 1 except for changing the means for spray injection, injection amount and manner of injection on the roller width direction as shown in Table 1. The results obtained are shown in Table 1.

### Comparative Example 1

The printing was performed in the same manner as in Example 1 except that the spray injection of dampening water (ECOLITY-2/water = 2/98 (volume ratio)) in step (ii) was not conducted. The results obtained are shown in Table 1.

### Comparative Example 2

The printing was performed in the same manner as in Example 1 except that after step (ii) the rotation of the water feed rollers was not conducted in step (iii) and the dampening roller and the inking roller were brought into contact with the lithographic printing plate precursor on the plate cylinder at the same time. The results obtained are shown in Table 1.

### Comparative Example 3

The printing was performed in the same manner as in Example 1 except that the spray injection of dampening water (ECOLITY-2/water = 2/98 (volume ratio)) in step (ii) was conducted not to the roller (22) of Fig. 4 but directly to the lithographic printing plate precursor mounted on the plate cylinder. The results obtained are shown in Table 1.

### Comparative Example 4

The printing was performed in the same manner as in Comparative Example 3 except that the rotation of the water feed rollers was not conducted in step (iii) and the dampening roller and the inking roller were brought into contact with the lithographic printing plate precursor on the plate cylinder at the same time. The results obtained are shown in Table 1.

### Comparative Example 5

The on-press development was performed without carrying out the spray injection of dampening water and by setting the amount of dampening water supplied from a water pan to the lithographic printing plate precursor at the on-press development 10 times (100 ml/m²) of that during printing, and then the amount of dampening water supplied was returned an ordinary supply amount of dampening water (10 ml/m²). The results obtained are shown in Table 1.

**TABLE 1**

| | Step (ii) | | | | | Step (iii) | On-press Development Property (number of waste sheets) | Presence or Absence of Printing Unevenness |
|---|---|---|---|---|---|---|---|---|
| | Presence or Absence of Spray Supply | Place for Supply (roller to be injected) | Supply Amount (ml/m²) | To Roller Width Direction | Supply Means | Rotation Number of Dampening Roller | | |
| Example 1 | Presence | Roller (22) | 50 | Uniform | Household Spray Bottle (sprayer) | 9 Times | 23 | A |
| Example 2 | Presence | Roller (22) | 50 | Uniform | Hand Spray Gun | 9 Times | 23 | A |
| Example 3 | Presence | Roller (22) | 50 | Uniform | Automatic Spray Gun (SprayCart III) | 9 Times | 22 | A |
| Example 4 | Presence | Roller (22) | 50 | Uniform | Portable Sprayer (Kiri-Tank) | 9 Times | 23 | A |
| Example 5 | Presence | Roller (22) | 50 | Aimed at place of poor damping feed | Household Spray Bottle (sprayer) | 9 Times | 20 | A |
| Example 6 | Presence | Roller (22) | 2 | Uniform | Household Spray Bottle (sprayer) | 9 Times | 34 | A |
| Example 7 | Presence | Roller (22) | 5 | Uniform | Household Spray Bottle (sprayer) | 9 Times | 23 | A |
| Example 8 | Presence | Roller (22) | 200 | Uniform | Household Spray Bottle (sprayer) | 9 Times | 23 | A |
| Comparative Example 1 | Absence | - | - | - | - | 9 Times | 35 | C (vertical |
| | | | | | | | | streak-like unevenness) |
| Comparative Example 2 | Presence | Roller (22) | 50 | Uniform | Household Spray Bottle (sprayer) | - | 40 | C (dot-like unevenness) |
| Comparative Example 3 | Presence | Printing Plate Precursor on Plate Cylinder | 50 | Uniform | Household Spray Bottle (sprayer) | 9 Times | 35 | C (dot-like unevenness) |
| Comparative Example 4 | Presence | Printing Plate Precursor on Plate Cylinder | 50 | Uniform | Household Spray Bottle (sprayer) | - | 50 | D (dot-like unevenness) |
| Comparative Example5 | Absence | - | - | - | - | 9 Times | 23 | C (vertical streak-like unevenness) |

| | | | | | | | | |
|---|---|---|---|---|---|---|---|---|
| Note 1: In Comparative Examples 2 and 4, step (iii) was not conducted and the dampening roller and the inking roller were brought into contact with the lithographic printing plate precursor on the plate cylinder at the same time to start printing. Note 2: In Comparative Example 5, the supply amount of dampening water was set at 100 ml/m² at the on-press development, and it was set at 10 ml/m² during printing. | | | | | | | | |

From the results shown in Table 1, it can be seen that the printing unevenness is eliminated by injecting the dampening water to the water feed rollers and that the on-press development property is improved by increasing the injection amount of dampening water.

In Comparative Example 1 wherein the spray supply to the roller was omitted, the on-press development property was poor and the vertical streak-like printing unevenness which seemed to be resulting from the roller occurred.

In Comparative Example 2 wherein the spray supply to the roller was conducted but step (iii) was omitted, the liquid supplied was not uniformized on the roller and water droplets were formed on the peripheral surface of the roller to deteriorate the on-press development property. Further, the dot-like printing unevenness which seemed to be resulting from the water droplets occurred.

In Comparative Example 3 wherein the dampening water was supplied directly to the lithographic printing plate precursor, since the dampening water did not uniformly supplied on the surface of lithographic printing plate precursor, the dot-like printing unevenness which seemed to be resulting from the development unevenness occurred from the start of printing.

In Comparative Example 4 wherein step (ii) was omitted, the on-press development property and the dot-like printing unevenness were more deteriorated than those in Comparative Example 3.

In Comparative Example 5 wherein the spray supply to the roller was omitted but the supply amount of dampening water from a water pan was increased 10 times, although the on-press development property was good, the printing unevenness occurred.

### Examples 9 to 16 and Comparative Examples 6 to 8

The printing and evaluation were performed under the same conditions except for changing the dampening water for spray injection in Examples 1 to 8 and Comparative Examples 2 to 4 from ECOLITY-2/water = 2/98 (volume ratio) to ECOLITY-2 stock solution (ECOLITY-2/water = 100/0). The results obtained are shown in Table 2. In Table 2, the results of Comparative Examples 1 and 5 are also shown for comparison.

**TABLE 2**

| | Step (ii) | | | | | Step (iii) | On-press Development Property (number of waste sheets) | Presence or Absence of Printing Unevenness |
|---|---|---|---|---|---|---|---|---|
| | Presence or Absence of Spray Supply | Place for Supply (roller to be injected) | Supply Amount (ml/m²) | To Roller Width Direction | Supply Means | Rotation Number of Dampening Roller | | |
| Example 9 | Presence | Roller (22) | 50 | Uniform | Household Spray Bottle (sprayer) | 9 Times | 14 | A |
| Example 10 | Presence | Roller (22) | 50 | Uniform | Hand Spray Gun | 9 Times | 14 | A |
| Example 11 | Presence | Roller (22) | 50 | Uniform | Automatic Spray Gun (SprayCart III) | 9 Times | 13 | A |
| Example 12 | Presence | Roller (22) | 50 | Uniform | Portable Sprayer (Kiri-Tank) | 9 Times | 14 | A |
| Example 13 | Presence | Roller (22) | 50 | Aimed at place of poor damping feed | Household Spray Bottle (sprayer) | 9 Times | 11 | A |
| Example 14 | Presence | Roller (22) | 2 | Uniform | Household Spray Bottle (sprayer) | 9 Times | 25 | A |
| Example 15 | Presence | Roller (22) | 5 | Uniform | Household Spray Bottle (sprayer) | 9 Times | 14 | A |
| Example 16 | Presence | Roller (22) | 200 | Uniform | Household Spray Bottle (sprayer) | 9 Times | 14 | A |
| Comparative Example 1 | Absence | - | - | - | - | 9 Times | 35 | C (vertical |
| | | | | | | | | streak-like unevenness) |
| Comparative Example 6 | Presence | Roller (22) | 50 | Uniform | Household Spray Bottle (sprayer) | - | 31 | C (dot-like unevenness) |
| Comparative Examples 7 | Presence | Printing Plate Precursor on Plate Cylinder | 50 | Uniform | Household Spray Bottle (sprayer) | 9 Times | 26 | C (dot-like unevenness) |
| Comparative Example 8 | Presence | Printing Plate Precursor on Plate Cylinder | 50 | Uniform | Household Spray Bottle (sprayer) | - | 41 | D (dot-like unevenness) |
| Comparative Example 5 | Absence | - | - | - | - | 9 Times | 23 | C (vertical streak-like unevenness) |

From the comparison of Table 1 with Table 2, it can be seen that the better results are obtained in the case where the dampening water for the spray supply has higher concentration than that of the dampening water used during printing.

### Examples 17 to 27

The printing and evaluation were performed under the same conditions in Example 1 except for changing the dampening water for the spray injection in Example 1 to the kind of liquid shown in Table 3. The results obtained are shown in Table 3. In Table 3, the results of Examples 1 and 9 and Comparative Examples 1 and 5 are also shown for comparison.

**TABLE 3**

| | Stop (ii) | | On-press Development Property (number of waste sheets) | Presence or Absence of Printing Unevenness |
|---|---|---|---|---|
| | Presence or Absence of Spray Supply | Kind of Liquid for Injection | | |
| Example 1 | Presence | Ecolity-2/Water = 2/98 (volume ratio) | 23 | A |
| Example 17 | Presence | Ecolity-2/Water = 50/50 (volume ratio) | 17 | A |
| Example 18 | Presence | Ecolity-2/Water = 10/90 (volume ratio) | 20 | A |
| Example 9 | Presence | Ecolity-2 Stock Solution | 14 | A |
| Example 19 | Presence | Methyl Ethyl Ketone/Water= 20/80 (volume ratio) | 20 | A |
| Example 20 | Presence | 1-Methoxy-2-propanol/Water = 50/50 (volume ratio) | 20 | A |
| Example 21 | Presence | Polyethylene Glycol(Mw:600)/Water = 50/50 (volume ratio) | 15 | A |
| Example 22 | Presence | Methanol/Water = 50/50 (volume ratio) | 11 | A |
| Example 23 | Presence | Ethanol/Water = 50/50 (volume ratio) | 8 | A |
| Example 24 | Presence | Isopropylalcohol | 5 | A |
| Example 25 | Presence | Isopropylalcohol/Water = 50/50 (volume ratio) | 10 | A |
| Example 26 | Presence | Isopropylalcohol/Water = 10/90 (volume ratio) | 15 | A |
| Example 27 | Presence | Methyl Acetate/Water = 25/75 (volume ratio) | 13 | A |
| Comparative Example 1 | Absence | - | 35 | C (vertical streak-like unevenness) |
| Comparative Example 5 | Absence | - | 23 | C (vertical streak-like unevenness) |

In the case where the composition of the dampening water for spraying is same, as the concentration increases the good results are obtained.

In the case where the aqueous solution of water-miscible solvent is sprayed, the good results are obtained. In particular, the image-recording layer is easily developed with layer stripping or dissolution so that the on-press development property tends to be improved in comparison with the spray of dampening water.

In the spraying of the aqueous solution of water-miscible solvent and in the spraying of the dampening water of high concentration, the concentration of liquid supplied by spraying was decreased by dampening water (ordinary concentration) supplied from a water pan after the on-press development so that the printing was stably performed without any trouble.

### Examples 28 to 33

The printing and evaluation were performed in the same manner as in Example 9 except that after the injection of spray solution, the water feed rollers were rotated at the rotation number shown in Table 4.

**TABLE 4**

| | Stop (ii) | Step (iii) | On-press Development Property (number of waste sheets) | Presence or Absence of Printing Unevenness |
|---|---|---|---|---|
| | Presence or Absence of Spray Supply | Rotation Number of Dampening Roller | | |
| Example 28 | Presence | 2 | 16 | B |
| Example 29 | Presence | 3 | 14 | A |
| Example 9 | Presence | 9 | 14 | A |
| Example 30 | Presence | 20 | 14 | A |
| Example 31 | Presence | 25 | 18 | A |
| Example 32 | Presence | 50 | 20 | A |
| Example 33 | Presence | 100 | 35 | A |
| Comparative Example 1 | Absence | 9 | 35 | C (vertical streak-like unevenness) |
| Comparative Example 5 | Absence | 9 | 23 | C (vertical streak-like unevenness) |

In the range of the rotation number from 3 to 20, the liquid injected is mixed with the dampening water supplied from a water pan to provide good on-press development property, but when the rotation number exceeds the range, the concentration of the liquid injected comes close to that of the dampening water supplied from a water pan to deteriorate the on-press development property. Also, when the rotation number is small, the printing unevenness occurs but slightly.

### Example 34

Lithographic printing plate precursor (1) which had been exposed and mounted on the plate cylinder of printing machine in the same manner as in Example 9 was subjected to printing in the order of steps (iii) → (ii) → (iv) → (v) shown below.

In the rotation of water feed rollers of step (iii), the rotation was conducted 9 times in terms of rotation number of a dampening roller.

In the injection of dampening water of step (ii), the dampening water (ECOLITY-2 stock solution at temperature of 25°C) was uniformly injected to the roller (22) by a household spray bottle (sprayer) at a ratio of 50 ml/m² per unit area of the lithographic printing plate precursor mounted on the plate cylinder.

In the bringing the dampening roller into contact with the lithographic printing plate precursor of step (iv), the dampening roller was brought into contact with the lithographic printing plate precursor, and then the plate cylinder was rotated 10 times.

In the supply of printing ink from the inking roller to the lithographic printing plate precursor and supply of printing paper to the plate cylinder of step (v), printing paper (TOKUBISHI art paper (76.5 kg)) was supplied at the same time as the ink supply. The printing was performed at a printing speed of 6,000 sheets per hour. The results obtained are shown in Table 5.

**TABLE 5**

| | Stop (ii) | Oder of Steps | On-press Development Property (number of waste sheets) | Presence or Absence of Printing Unevenness |
|---|---|---|---|---|
| | Presence or Absence of Spray Supply | | | |
| Example 9 | Presence | (i) → (ii) → (iii) → (iv) → (v) | 14 | A |
| Examples 34 | Presence | (i) → (iii) → (ii) → (iv) → (v) | 14 | B |
| Comparative Example 1 | Absence | 9 | 35 | C (vertical streak-like unevenness) |
| Comparative Example 5 | Absence | 9 | 23 | C (vertical streak-like unevenness) |

In Example 34 wherein the order of steps was changed, it was confirmed that both the on-press development property and the printing unevenness were superior to Comparative Examples 1 and 5 wherein the spray supply was not conducted.

### Example 35 to 38

In step (iv), after the dampening roller was brought into contact with the lithographic printing plate precursor and the plate cylinder was rotated 5 times, the dampening roller was separated from the lithographic printing plate precursor and the rotation of the water feed rollers was stopped at the same time. After allowing to stand for the period of time shown in Table 6, the dampening roller was again brought into contact with the lithographic printing plate precursor and the plate cylinder was rotated 5 times. Other than those above, the printing was initiated in the same manner as in Example 9.

**TABLE 6**

| | Stop (ii) | Step (iv) | On-press Development Property (number of waste sheets) | Presence or Absence of Printing Unevenness |
|---|---|---|---|---|
| | Presence or Absence of Spray Supply | Temporary Stop Time in Step (iv) (minutes) | | |
| Example 9 | Presence | 0 | 14 | A |
| Example 35 | Presence | 3 | 12 | A |
| Example 36 | Presence | 5 | 10 | A |
| Example 37 | Presence | 10 | 12 | A |
| Example 38 | Presence | 30 | 20 | A |
| Comparative Example 1 | Absence | 0 | 35 | C (vertical streak-like unevenness) |
| Comparative Example 5 | Absence | 0 | 23 | C (vertical streak-like unevenness) |

From the results shown in Table 6, it can be seen that the temporary stop time is preferably from 3 to 10 minutes in view of the on-press development property.

### Examples 39 and 40

The printing and evaluation were performed in the same manner as in Example 9 except for changing Lithographic printing plate precursor (1) used in Example 9 to the lithographic printing plate precursor shown in Table 7. The results obtained are shown in Table 7.

### Comparative Examples 9 and 10

The printing and evaluation were performed in the same manner as in Examples 39 and 40 except that the spray injection of dampening water (ECOLITY-2/water = 2/98 stock solution) in step (ii) was not conducted in Examples 39 and 40, respectively. The results obtained are shown in Table 7.

**TABLE 7**

| | Lithographic Printing Plate Precursor | Stop (ii) | On-press Development Property (number of waste sheets) | Presence or Absence of Printing Unevenness |
|---|---|---|---|---|
| | | Presence or Absence of Spray Supply | | |
| Example 9 | Lithographic Printing Plate Precursor (1) | Presence | 14 | A |
| Example 39 | Lithographic Printing Plate Precursor (2) | Presence | 20 | A |
| Example 40 | Lithographic Printing Plate Precursor (3) | Presence | 20 | A |
| Comparative Example 9 | Lithographic Printing Plate Precursor (2) | Absence | 41 | C (vertical streak-like unevenness) |
| Comparative Example 10 | Lithographic Printing Plate Precursor (3) | Absence | 41 | C (vertical streak-like unevenness) |

### Examples 41 to 43

The printing and evaluation were performed in the same manner as in Example 9 except for changing the place for the spray injection in step (ii) to the place shown in Table 8. The results obtained are shown in Table 8.

**TABLE 8**

| | Step (ii) | | On-press Development Property (number of waste sheets) | Presence or Absence of Printing Unevenness |
|---|---|---|---|---|
| | Presence or Absence of Spray Supply | Place for Supply (roller to be injected) | | |
| Examples 9 | Presence | Roller (22) | 14 | A |
| Example 41 | Presence | Roller (21) | 15 | A |
| Example 42 | Presence | Roller (24) | 15 | A |
| Example 43 | Presence | Roller (25) | 14 | A |
| Comparative Example 1 | Absence | - | 35 | C (vertical streak-like unevenness) |
| Comparative Example 5 | Absence | - | 23 | C (vertical streak-like unevenness) |

To supply the water to the roller for supplying water to dampening roller or the metering roller slightly improves the on-press development property than to supply the water to the dampening roller or the roller for stabilizing water amount.

### INDUSTRIAL APPLICABILITY

According to the invention, a printing method using a lithographic printing plate precursor capable of undergoing on-press development, which is a simple printing method for improving on-press development property (that is, decreasing a number of waste sheets at the start of printing) and avoiding the occurrence of unevenness in printed materials, can be provided.

### DESCRIPTION OF REFERENCE NUMERALS AND SIGNS

- 10:: Plate cylinder
- 20:: Water feed rollers
- 21:: Dampening roller
- 22:: Roller for supplying water to dampening roller
- 23:: Water pan roller
- 24:: Roller for stabilizing water amount
- 25:: Metering roller
- 30:: Ink rollers
- 31:: Inking roller
- 32:: Distributing roller
- 40:: Bridge roller
- 50:: Water pan

## Claims

1. A printing method of a lithographic printing plate precursor having on an aluminum support, an image-recording layer capable of being developed by supplying at least any of printing ink and dampening water, wherein steps (i) to (v) shown below are performed at start of printing in order of (i), (ii), (iii), (iv) and (v) or in order of (i), (iii), (ii), (iv) and (v):
(i) exposing imagewise the lithographic printing plate precursor and then mounting on a plate cylinder of a printing machine;
(ii) supplying by spraying at least any of dampening water and an aqueous solution containing an organic solvent to at least any of a dampening roller, a roller for supplying water to dampening roller, a roller for stabilizing water amount and a metering roller, which are dampening water supply means of the printing machine;
(iii) rotating water feed rollers without the dampening roller being brought into contact with the lithographic printing plate precursor;
(iv) bringing the dampening roller into contact with the lithographic printing plate precursor to supply dampening water from the dampening roller to the lithographic printing plate precursor;
(v) bringing an inking roller into contact with the lithographic printing plate precursor to supply printing ink from the inking roller to the lithographic printing plate precursor, and supplying printing paper at the same time as or after the bringing an inking roller into contact with the lithographic printing plate precursor.

2. The printing method as claimed in Claim 1, wherein the steps of (i) to (v) at the start of printing is performed in order of (i), (ii), (iii), (iv) and (v), and after being rotated the water feed rollers from 1 to 50 rotations in step (iii), the dampening roller is brought into contact with the lithographic printing plate precursor.

3. The printing method as claimed in Claim 1 or 2, after bringing the dampening roller into contact with the lithographic printing plate precursor in step (iv) the contact is released once, and within 30 minutes after the releasing, the dampening roller is again brought into contact with the lithographic printing plate precursor.

4. The printing method as claimed in any one of Claims 1 to 3, wherein the organic solvent in the solution containing an organic solvent for injecting in step (ii) is a solvent miscible with water.

5. The printing method as claimed in Claim 4, wherein the organic solvent is an alcohol solvent, an ester solvent, an ether solvent or a ketone solvent.

6. The printing method as claimed in any one of Claims 1 to 3, wherein the dampening water for injecting in step (ii) has same composition as dampening water used during printing and has high concentration.

7. The printing method as claimed in any one of Claims 1 to 6, wherein the image-recording layer contains an infrared absorbing agent, a polymerization initiator, a radical polymerizable compound and a binder polymer.

8. The printing method as claimed in Claim 7, wherein the binder polymer is an acrylic resin binder having polyethylene oxide or polypropylene oxide in its side chain.

9. The printing method as claimed in any one of Claims 1 to 8, wherein the lithographic printing plate precursor has an undercoat layer containing a polymer compound having a hydrophilic group and a group adsorbing to a surface of the support between the aluminum support and the image-recording layer.

## Patentansprüche

1. Druckverfahren für einen
Lithographiedruckplattenvorläufer, der auf einem Aluminiumträger eine Bildaufzeichnungsschicht aufweist, die durch Zuführen von zumindest einem von Drucktinte und Anfeuchtwasser entwickelt werden kann, worin die nachstehend gezeigten Schritt (i) bis (v) zum Beginn des Druckens in der Reihenfolge (i), (ii), (iii), (iv) und (v) oder in der Reihenfolge (i), (iii), (ii), (iv) und (v) durchgeführt werden:
(i) bildweises Belichten des Lithographiedruckplattenvorläufers, und dann Montieren hiervon auf einem Plattenzylinder einer Druckmaschine;
(ii) Zuführen durch Sprühen von zumindest einem von Anfeuchtwasser und einer wässrigen Lösung, die ein organisches Lösungsmittel enthält, zu zumindest irgendeinem einer Anfeuchtwalze, einer Walze zum Zuführen von Wasser zu einer Anfeuchtwalze, einer Walze zum Stabilisieren der Wassermenge und einer Zuführwalze, welche die Anfeuchtwasser-Zuführmittel der Druckmaschine sind;
(iii) Rotieren von Wasser-Zuführwalzen, ohne dass die Anfeuchtwalze in Kontakt mit dem Lithographiedruckplattenvorläufer gebracht wird;
(iv) in-Kontakt-bringen der Anfeuchtwalze mit dem Lithographiedruckplattenvorläufer, um Anfeuchtwasser aus der Anfeuchtwalze zu dem Lithographiedruckplattenvorläufer zuzuführen;
(v) in-Kontakt-bringen einer Tintenzuführwalze mit dem Lithographiedruckplattenvorläufer, um Drucktinte von der Tintenzuführwalze zu dem Lithographiedruckplattenvorläufer zuzuführen, und Zuführen von Druckpapier zu der gleichen Zeit wie oder nach dem in-Kontakt-bringen der Tintenzuführwalze mit dem Lithographiedruckplattenvorläufer.

2. Druckverfahren gemäß Anspruch 1, worin die Schritte (i) bis (v) zum Beginn des Druckens in der Reihenfolge (i), (ii), (iii), (iv) und (v) durchgeführt werden, und nachdem die Wasser-Zuführwalzen im Schritt (iii) 1 bis 50 Umdrehungen durchgeführt haben, die Anfeuchtwalze in Kontakt mit dem Lithographiedruckplattenvorläufer gebracht wird.

3. Druckverfahren gemäß Anspruch 1 oder 2, worin nach dem in-Kontakt-bringen der Anfeuchtwalze mit dem Lithographiedruckplattenvorläufer in Schritt (iv) der Kontakt einmal gelöst wird, und innerhalb von 30 Minuten nach dem Lösen die Anfeuchtwalze wieder in Kontakt mit dem Lithographiedruckplattenvorläufer gebracht wird.

4. Druckverfahren gemäß irgendeinem der Ansprüche 1 bis 3, worin das organische Lösungsmittel in der Lösung, die ein organisches Lösungsmittel enthält, zum Einspritzen im Schritt (ii) ein Lösungsmittel ist, das mit Wasser mischbar ist.

5. Druckverfahren gemäß Anspruch 4, worin das organische Lösungsmittel ein alkoholisches Lösungsmittel, ein Ester-Lösungsmittel, ein Ether-Lösungsmittel oder Keton-Lösungsmittel ist.

6. Druckverfahren gemäß irgendeinem der Ansprüche 1 bis 3, worin das Anfeuchtwasser zum Einspritzen im Schritt (ii) die gleiche Zusammensetzung wie Anfeuchtwasser aufweist, das während des Druckens verwendet wird, und eine hohe Konzentration aufweist.

7. Druckverfahren gemäß irgendeinem der Ansprüche 1 bis 6, worin die Bildaufzeichnungsschicht einen Infrarotabsorber, einen Polymerisationsinitiator, eine radikalisch polymerisierbare Verbindung und ein Bindepolymer enthält.

8. Druckverfahren gemäß Anspruch 7, worin das Bindepolymer ein Acrylharz-Bindemittel ist, das in dessen Seitenkette Polyethylenoxid oder Polypropylenoxid aufweist.

9. Druckverfahren gemäß irgendeinem der Ansprüche 1 bis 8, worin der Lithographiedruckplattenvorläufer zwischen dem Aluminiumträger und der Bildaufzeichnungsschicht eine Unterzugsschicht aufweist, die eine Polymerverbindung enthält, die eine hydrophile Gruppe und eine Gruppe, die an eine Oberfläche des Trägers adsorbieren kann, aufweist.

## Revendications

1. Procédé d'impression d'un précurseur de plaque d'impression lithographique ayant, sur un support en aluminium, une couche d'enregistrement d'image capable d'être développée en approvisionnant au moins l'une quelconque d'une encre d'impression et d'une eau de mouillage, dans lequel les étapes (i) à (v) présentées ci-dessous sont effectuées au début de l'impression dans l'ordre (i), (ii), (iii), (iv) et (v) ou dans l'ordre (i), (iii), (ii), (iv) et (v) :
(i) exposer image par image le précurseur de plaque d'impression lithographique et le monter ensuite sur un cylindre porte-plaque d'une machine à imprimer ;
(ii) fournir par pulvérisation au moins l'une quelconque d'une eau de mouillage et d'une solution aqueuse contenant un solvant organique à l'un au moins quelconque d'un rouleau de mouillage, d'un rouleau pour fournir de l'eau au rouleau de mouillage, d'un rouleau pour stabiliser la quantité d'eau et d'un rouleau de dosage, qui sont des moyens d'approvisionnement en eau de mouillage de la machine à imprimer;
(iii) faire tourner les rouleaux d'alimentation en eau sans que le rouleau de mouillage ne soit amené en contact avec le précurseur de plaque d'impression lithographique ;
(iv) amener le rouleau de mouillage en contact avec le précurseur de plaque d'impression lithographique pour fournir de l'eau de mouillage du rouleau de mouillage au précurseur de plaque d'impression lithographique;
(v) amener un rouleau encreur en contact avec le précurseur de plaque d'impression lithographique pour fournir de l'encre d'impression du rouleau encreur au précurseur de plaque d'impression lithographique, et fournir du papier d'impression en même temps ou après avoir amené un rouleau encreur en contact avec le précurseur de plaque d'impression lithographique.

2. Procédé d'impression selon la revendication 1, dans lequel les étapes (i) à (v) au début de l'impression sont effectuées dans l'ordre (i), (ii), (iii), (iv) et (v), et après que les rouleaux d'alimentation en eau aient été tournés de 1 à 50 rotations à l'étape (iii), le rouleau de mouillage est amené en contact avec le précurseur de plaque d'impression lithographique.

3. Procédé d'impression selon la revendication 1 ou 2, dans lequel après avoir amené le rouleau de mouillage en contact avec le précurseur de plaque d'impression lithographique dans l'étape (iv), le contact est relâché une fois, et dans les 30 minutes après le relâchement, le rouleau de mouillage est à nouveau amené en contact avec le précurseur de plaque d'impression lithographique.

4. Procédé d'impression selon l'une quelconque des revendications 1 à 3, dans lequel le solvant organique dans la solution contenant un solvant organique pour l'injection dans l'étape (ii) est un solvant miscible à l'eau.

5. Procédé d'impression selon la revendication 4, dans lequel le solvant organique est un solvant alcool, un solvant ester, un solvant éther ou un solvant cétone.

6. Procédé d'impression selon l'une quelconque des revendications 1 à 3, dans lequel l'eau de mouillage pour l'injection dans l'étape (ii) a la même composition que l'eau de mouillage utilisée lors de l'impression et a une concentration élevée.

7. Procédé d'impression selon l'une quelconque des revendications 1 à 6, dans lequel la couche d'enregistrement d'image contient un agent absorbant l'infrarouge, un initiateur de polymérisation, un composé polymérisable par voie radicalaire et un polymère de liaison.

8. Procédé d'impression selon la revendication 7, dans lequel le polymère de liaison est un liant de résine acrylique ayant un oxyde de polyéthylène ou un oxyde de polypropylène dans sa chaîne latérale.

9. Procédé d'impression selon l'une quelconque des revendications 1 à 8, dans lequel le précurseur de plaque d'impression lithographique a une couche de sous-revêtement contenant un composé polymère ayant un groupe hydrophile et un groupe d'adsorption à une surface du support entre le support en aluminium et la couche d'enregistrement d'image.
